(19) Europäisches Patentamt / European Patent Office / Office européen des brevets

(11) **EP 4 459 868 B1**

(12) **EUROPEAN PATENT SPECIFICATION**

(45) Date of publication and mention
of the grant of the patent:
**08.07.2026 Bulletin 2026/28**

(21) Application number: **23765752.3**

(22) Date of filing: **16.02.2023**

(51) International Patent Classification (IPC):
*H03K 17/081* (2006.01)  *H03K 17/72* (2006.01)
*H03K 17/00* (2006.01)  *H01F 29/04* (2006.01)
*H01H 9/00* (2006.01)  *H01H 9/42* (2006.01)

(52) Cooperative Patent Classification (CPC):
**H01F 29/04; H01H 9/0011; H01H 9/0016;
H01H 9/42;** H01H 9/542

(86) International application number:
**PCT/CN2023/076537**

(87) International publication number:
**WO 2023/169174 (14.09.2023 Gazette 2023/37)**

(54) **NO-ARC ON-LOAD TAP CHANGER, SWITCHING CONTROL METHOD AND ELECTRICAL EQUIPMENT**

LICHTBOGENFREIER LASTSTUFENSCHALTER, SCHALTSTEUERUNGSVERFAHREN UND ELEKTRISCHE AUSRÜSTUNG

CHANGEUR DE PRISES EN CHARGE SANS ARC, PROCÉDÉ DE COMMANDE DE COMMUTATION ET ÉQUIPEMENT ÉLECTRIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **09.03.2022 CN 202210232941**

(43) Date of publication of application:
**06.11.2024 Bulletin 2024/45**

(73) Proprietor: **Li, Xiaoming
Shandong 250002 (CN)**

(72) Inventor: **Li, Xiaoming
Shandong 250002 (CN)**

(74) Representative: **Lorenz Seidler Gossel Part. mbB
Widenmayerstr. 23
80538 München (DE)**

(56) References cited:
WO-A1-02/093600          CN-A- 108 768 359
CN-A- 108 768 359        CN-A- 112 071 672
CN-A- 112 466 691        CN-A- 114 783 743
DE-A1- 1 438 592         US-A- 4 201 938

## Description

The present invention claims priority benefits to Chinese Patent Application number202210232941.2, entitled "a no-arc on-load tap changer, switching control method and electrical equipment", filed on March 9, 2022, with the China National Intellectual Property Administration (CNIPA).

## TECHNICAL FIELD

The present invention belongs to the technical field of power transmission and transformation of power systems, and particularly relates to a no-arc on-load tap changer, a switching control method and electrical equipment.

## BACKGROUND

The statements in this section merely provide background information related to the present invention and do not necessarily constitute prior art.

Under the condition that the transformer has load current (on-load), it is necessary to use an on-load tap changer to switch the tap of one voltage of the transformer to the tap of another voltage, and to ensure that the power user does not lose power during the switching process. Wherein, the on-load tap changer refers to a voltage regulating device suitable for operating under transformer excitation or load and used to change the tap connection position of transformer windings, and the basic principle thereof is to realize the switching between the transformer winding taps without interrupting the load current, so as to change the number of turns of the winding, that is, the voltage ratio of the transformer, and finally realize the purpose of voltage regulation.

The resistance transition mode is generally adopted in the existing on-load tap changer to realize the switching process of two different voltage taps. However, the resistance transition mode has the defect of radian in the switching process.

Chinese publication patent number CN103019284A, CN103633978A and CN104113317A respectively introduced different no-arc on-load tap changers, but since the oil-immersed on-load tap changer is suitable to be driven by a rotary shaft, and the inventors have found that, the devices proposed in the above patents are mainly used in circuits composed of contactors or relay contacts, while the no-arc on-load tap changers composed of contactors or relays are not suitable for using in oil immersed transformers.

An on-load tap changer in the solution of the on-load tap changer provided in the Chinese publication patent number CN108768359A has a structure driven by a rotary shaft, however, the inventor found that this patent is still complicated in operating structure because various switches are distributed on two or three rotary shafts which are not synchronized, so that when one rotary shaft needs to rotate, the other rotary shaft needs to be stationary; moreover, it lacks a coordination control mechanism between rotary shafts, a matching scheme between dynamic contacts and static contacts of rotary shafts, and a driving scheme for controlling switches; moreover, the dynamic contacts and the static contacts of the various switches of the CN108768359A are complicated in structure, and the structures of the control switches (KA1, KB1, KA2, KB2) are not researched enough in the CN108768359A.

## SUMMARY

In order to solve the technical problems existing in the background, the present invention provides a no-arc on-load tap changer, a switching control method, and electrical equipment, wherein the no-arc on-load tap changer is suitable for an oil-immersed transformer driven by a rotary shaft, and has the advantages of simple operation structure and less time for a complete switching process.

In order to achieve the above object, the present invention adopts the following technical solution.

A first aspect of the present invention provides a no-arc on-load tap changer according to claim 1 of the present application.

In one or more embodiments, providing a first type of structure of the no-arc on-load tap changer, including at least two main switches, two change-over switches and two thyristor auxiliary modules; wherein, each of the two thyristor auxiliary modules includes two control switches; the two main switches include an originally-closed main switch and a to-be-closed main switch; the two main switches are connected in corresponding loops of a voltage regulating coil through taps of corresponding transformers; the two thyristor auxiliary modules are connected in parallel with the originally-closed main switch or the to-be-closed main switch according to a required time sequence during a switching process of main switch;

the two main switches and the two change-over switches are all rotary-shaft-type switches, dynamic contacts of the two main switches and dynamic contacts of the two change-over switches are all arranged on a rotary shaft, static contacts respectively corresponding to the two main switches and the two change-over switches are connected to the taps of the corresponding transformers, and the dynamic contacts are connected with coaxial static contacts in a process of rotating along with the rotary shaft; wherein, according to a preset time sequence, controlling corresponding ones of the two main switches, corresponding ones of the two change-over switches, and corresponding ones of the control switches to be broken and closed, to realize that a load current is transferred from the originally-closed main switch to the to-be-closed main switch without interruption, and no arc in the breaking and closing process of each of the two main switches, the two change-over switches, and the control switches.

As an implementation mode, a first end of the each of the two thyristor auxiliary modules is suspended or connected in parallel with the originally-closed main switch before carrying out the switching process of main switch, and a voltage at both ends of the each of the two thyristor auxiliary modules is zero.

As an implementation mode, each of the control switches is also a rotary-shaft-type switch, and dynamic contacts of the control switches are also arranged on the rotary shaft.

As an implementation mode, all the static contacts of the two main switches and the two change-over switches are divided into at least two groups, each of the two groups of the static contacts is correspondingly mounted on a track, and the two tracks are centered on the rotary shaft and fixed.

As an implementation mode, a number of the static contacts in the each of the two groups of the static contacts are the same.

As an implementation mode, the static contacts in the each of the two groups of the static contacts are mounted on the two tracks with equal radians.

As an implementation mode, when all the static contacts of the two main switches and the two change-over switches are divided into the two groups, relationships of radians of the static contacts on corresponding one of the two tracks are:

$$0 < \Delta W < W1 < 0.5W < W2,$$

$$\Delta W = \left( W - W2 \right),$$

wherein: W and $W1$ respectively are radians between center positions of the static contacts and radians of the static contacts on a first track of the two tracks, $W2$ and $\Delta W$ respectively are radians of the static contacts and radians of gaps between the static contacts on a second track of the two tracks.

As an implementation mode, before the switching process of main switch, a normal operating state of the no-arc on-load tap changer is:

one of the dynamic contacts on the rotary shaft is located on a center line of one of the static contacts, and remaining the dynamic contacts are respectively located on center lines of gaps between the static contacts.

As an implementation mode, when three the dynamic contacts are provided on the rotary shaft, a first dynamic contact of the three dynamic contacts and a second dynamic contact of the three dynamic contacts respectively are arranged on each side of a third dynamic contact of the three dynamic contacts, then relationships of radians between the three dynamic contacts are:

$$0 < \Delta W < W_{1dynamic} < 0.5W < W_{2dynamic}$$

$$\Delta W_{dynamic} = \left( W - W_{2dynamic} \right)$$

Wherein W is the radian between the center positions of the static contacts on the first track, $W_{1dynamic}$ and $W_{2dynamic}$ respectively are the radian of the first dynamic contact and the second dynamic contact, $\Delta W_{dynamyc}$ is the radian of the gap between the first dynamic contact and the second dynamic contact.

As an implementation mode, the radians of the static contacts are greater than the radians of the dynamic contacts.

As an implementation mode, the radians of the static contacts are less than or equal to the radians of the dynamic contacts.

As an implementation mode, the breaking and closing of the control switch is controlled by a control mechanism.

As an implementation mode, the control mechanism is of a mechanical linkage mechanism.

As an implementation mode, the mechanical linkage mechanism includes a deflection shaft, wherein the deflection shaft is fixed on a rotary shaft and rotates along with the rotary shaft; a lever arm and a spring arm which can rotate around the deflection shaft are mounted on the deflection shaft; one end of the spring arm is provided with a contact; and the contact makes contact with or detached from corresponding ones of the control switches along with rotation of the rotary shaft, so that the corresponding ones of the control switches are broken and closed, respectively.

As an implementation mode, a control means for the control mechanism is realized by driving the change-over switches by the rotary shaft.

As an implementation mode, the structure of the two thyristor auxiliary modules is same.

As an implementation mode, the structure of the each of the two thyristor auxiliary modules comprises a pair of thyristors connected in reverse parallel; an RC series circuit is connected in parallel at two ends of the pair of the thyristors; a capacitor, a resistor and a diode are sequentially connected between a gate electrode and a cathode of each thyristor of the pair of the thyristors; an anode of the diode is connected with the cathode of corresponding one of the pair of the thyristors, and a cathode of the diode is connected with the gate electrode of the corresponding one of the pair of the thyristors; the gate electrodes of the pair of the thyristors are connected in series with one of the two control switches through a full-bridge rectifier circuit; two voltage-stabilizing tubes, a resistor, and another one of the two control switches are connected in series between the gate electrodes of the two the reverse-parallel-connected thyristors; wherein the two voltage-stabilizing tubes are connected in reverse series, the two voltage-stabilizing tubes are connected in series with the resistor and then connected with an output end of the full-bridge rectifier circuit, cathodes of the two voltage-stabilizing tubes corresponds to an anode output end of the full-bridge rectifier circuit, and anodes of the two voltage-stabilizing tubes corresponds to a cathode output end of the full-bridge rectifier circuit.

The present invention further provides a second type of structure of the no-arc on-load tap changer, including at least two main switches, two change-over switches and two thyristor auxiliary modules; wherein, each of the two thyristor auxiliary modules includes two control switches; the two main switches include an originally-closed main switch and a to-be-closed main switch; the two main switches are connected in corresponding loops of a voltage regulating coil through taps of corresponding transformers; the two thyristor auxiliary modules are connected with the originally-closed main switch or the to-be-closed main switch according to a required time sequence during the switching process of main switch.

The two main switches and the two change-over switches are all rotary-shaft-type switches, wherein the two main switches and corresponding ones of the two change-over switches are linked and synchronously rotated, respectively; corresponding main switches, change-over switches, and control switches are controlled to be broken and closed according to the preset time sequence, to realize that the load current is transferred from the originally-closed main switch to the to-be-closed main switch without interruption, and no arc in the breaking and closing process of each of the switches.

As an implementation mode, the control mechanism is of a mechanical linkage mechanism.

As an implementation mode, the mechanical linkage mechanism includes a deflection shaft, wherein the deflection shaft is fixed on a rotary shaft and rotates along with the rotary shaft; a lever arm and a spring arm which can rotate around the deflection shaft are mounted on the deflection shaft; one end of the spring arm is provided with a contact; and the contact makes contact with or detach from a corresponding control switch along with rotation of the rotary shaft, so that the corresponding control switch is broken and closed.

As an implementation mode, the control means of the control mechanism is realized by driving change-over switches by the rotary shaft.

As an implementation mode, the structure of the two thyristor auxiliary modules is same.

As an implementation mode, each of the two thyristor auxiliary module includes a pair of thyristors connected in reverse parallel; an RC series circuit is connected in parallel at two ends of the reverse-parallel-connected thyristors; a capacitor, a resistor and a diode are sequentially connected between a gate electrode and a cathode of each of the reverse-parallel-connected thyristors; an anode of the diode is connected with the cathode of the corresponding one of the reverse-parallel-connected thyristors, and a cathode of the diode is connected with the gate electrode of the corresponding one of the reverse-parallel-connected thyristors; the gate electrodes of the two the reverse-parallel-connected thyristors are connected in series with one of the two control switches through a full-bridge rectifier circuit; two voltage-stabilizing tubes, a resistor, and another one of the two control switches are connected in series between gate electrodes of the two the reverse-parallel-connected thyristors; wherein the two voltage-stabilizing tubes are connected in reverse series; the two voltage-stabilizing tubes are connected in series with the resistor and then connected with an output end of the full-bridge rectifier circuit; cathodes of the two voltage-stabilizing tubes corresponds to an anode output end of the full-bridge rectifier circuit; and anodes of the two voltage-stabilizing tubes corresponds to a cathode output end of the full-bridge rectifier circuit.

A second aspect of the present invention provides a switching control method for a no-arc on-load tap changer according to the claim 7 of the present application.

In one or more embodiments, the present invention provides a first type of the switching control method for the no-arc on-load tap changer, including:

controlling a rotation of the rotary shaft to drive the dynamic contacts to be connected with or detached from corresponding ones of the static contacts; controlling corresponding ones of the main switches, corresponding ones of the change-over switches, and corresponding ones of the control switches to be broken and closed according to the preset time sequence, to realize that the load current is transferred from the originally-closed main switch to the to-be-closed main switch without interruption, and no arc in the breaking and closing processes of all the switches.

As an implementation mode, a rotation mode of the rotary shaft includes a clockwise rotation and a counterclockwise rotation.

As an implementation mode, the process of one-time switching of main switch, including:

dynamic contacts of corresponding one of the two change-over switches contact with corresponding static contacts to close a first control switch of the thyristor auxiliary module connected with the originally-closed main switch, and breaking the originally-closed main switch;

closing a second control switch of the thyristor auxiliary module connected to the to-be-closed main switch and breaking the first control switch of the thyristor auxiliary module connected to the originally-closed main switch;

after a set time interval, closing a first control switch of the thyristor auxiliary module connected with the to-be-closed main switch, and closing the to-be-closed main switch; and

breaking all the control switches, and the dynamic contacts of the corresponding one of the two change-over switches are detached from the corresponding static contacts to complete the one-time switching of main switch.

As an implementation mode, before the switching of main switch, voltages between two ends of each of the two thyristor auxiliary modules are made to zero.

The present invention further provides a second type of the switching control method for the no-arc on-load tap changer, including:

controlling breakings and closings of the corresponding main switches and change-over switches by linking and synchronously rotating;
controlling corresponding main switches, change-over switches, and control switch to be broken and closed according to the preset time sequence, to realize that the load current is transferred from an originally-closed main switch to a to-be-closed main switch without interruption, and no arc in the breaking and closing processes of each of the switches.

A third aspect of the present invention provides an electric accessory according to the claim 10 of the present application.

In one or more embodiments, the electric accessory includes:

a voltage regulating coil, including a plurality of transformer taps; and
a no-arc on-load tap changer, being connected to the voltage regulating coil;
wherein the no-arc on-load tap changer is any one of the no-arc on-load tap changers described above.

Compared with the prior art, the present invention has the advantages that:

(1) The no-arc on-load tap changer provided by the present invention solves the problem that the existing no-arc on-load tap changer is not suitable for oil-immersed transformers by mounting the dynamic contacts on a rotary shaft and turning on with the corresponding static contacts along with the rotation of the rotary shaft. The no-arc on-load tap changer of the present invention adopts the rotary shaft as a driving power, and finally controls the originally-closed main switch, the change-over switches, the control switches and the to-be-closed main switch to perform matched breaking and closing according to preset time sequence, so as to realize no-arc switching and switching among the main switches in the breaking and closing process, and various switches and contacts can be operated in the oil tank of the oil-immersed transformer.
(2) The no-arc on-load tap changer provided by the present invention, can be realized on the basis of the basic structure of the existing oil-immersed on-load tap changer, also, can be realized on the basis of the basic structure of the existing oil-immersed on-load tap changer.
(3) The no-arc on-load tap changer provided by the present invention, the change-over switch includes a plurality of static contacts, the corresponding static contacts of the change-over switch are connected to the transformer tap, at least one control switch is mounted on the rotary shaft, and the breaking and closing thereof are controlled by the rotary shaft, so that the oil-immersed vacuum on-load tap changer can be upgraded on the basis of the basic structure of the existing oil-immersed vacuum on-load tap changer, and the switching between the main switches and no radian in the breaking and closing process can be realized.
(4) The no-arc on-load tap changer provided by the present invention, retains the accumulated experience in the past, simplifies the structure, reduces the volume, the weight, and the cost, has the benefits of small operating vibration, low failure rate, and short time of one-time complete switching process.

Advantages of additional aspects of the present invention will be set forth in part in the following description, and in part will become apparent from the following description, or may be learned by practice of the present invention.

BRIEF DESCRIPTION OF THE DRAWINGS

The accompanying drawings constituting a part of the present invention are used to provide a further understanding of the present invention. The exemplary examples of the present invention and descriptions thereof are used to explain the present invention, and do not constitute an improper limitation of the present invention.

FIG. 1 is a circuit diagram of a thyristor auxiliary module according to one embodiment of the present invention;
FIG. 2 is a structure diagram of a rotary shaft of a first-type no-arc on-load tap changer according to one embodiment of the present invention;
FIG. 3 is a horizontal expansion structure diagram of the first-type no-arc on-load tap changer according to one embodiment of the present invention;
FIG. 4 is a diagram showing a radian relationship of static contacts according to one embodiment of the present invention;
FIG. 5 is a structural diagram of switches KB 1 and KB2 according to one embodiment of the present invention; and
FIG. 6 is a structure diagram of a rotary shaft of a second type of the no-arc on-load tap changer according to one embodiment of the present invention;

In figures: 1, tap I; 2, tap II; 3,tap III; 4, rotary shaft; 5, fixed plate; 6, deflection shaft; 7, lever arm; 8, spring arm; 9, first circular hoop; 10, second circular hoop; 11, switch KB1; 12, switch KB2.

DETAILED DESCRIPTION

The present invention will now be further described below with reference to the accompanying drawings and embodiments.

It should be pointed out that the following detailed descriptions are all illustrative and are intended to provide further descriptions of the present invention. Unless otherwise specified, all technical and scientific terms used in the present invention have the same meanings as those usually understood by a person of ordinary skill in the art to which the present invention belongs.

It should be noted that the terms used herein are merely used for describing specific implementations, and are not intended to limit exemplary implementations of the present invention. As used herein, the singular form is also intended to include the plural form unless the context clearly dictates otherwise. In addition, it should further be understood that, terms "include" and/or "including" used in this specification indicate that there are features, steps, operations, devices, components, and/or combinations thereof.

<A no-arc on-load tap changer and a switching control method thereof>

In order to solve the problems that the existing no-arc on-load tap changer in the background art is not suitable for an oil-immersed transformer, and even if the no-arc on-load tap changer is suitable for the oil-immersed transformer, various switches are respectively distributed on two or three rotary shafts which are not synchronous, when one rotary shaft needs to rotate, the other rotary shaft needs to be stationary, the operation structure is complex, and a rotary shaft coordination control mechanism, a dynamic contact and a static contact matching scheme of the rotary shaft and a driving scheme for controlling the switch are lacking. To solve the above problems, a no-arc on-load tap changer and a corresponding switching control method are provided by the present invention.

Embodiment 1

The present embodiment provides a no-arc on-load tap changer, which includes at least two main switches, two change-over switches and two thyristor auxiliary modules; wherein, each of the two thyristor auxiliary modules includes two control switches; that the two main switches comprise an originally-closed main switch and a to-be-closed main switch; the two main switches are connected in corresponding loops of a voltage regulating coil through corresponding transformer taps; the two thyristor auxiliary modules are connected in parallel with the originally-closed main switch or the to-be-closed main switch according to a required time sequence during the switching of main switch; the two main switches and the two change-over switches are all rotary-shaft-type switches, dynamic contacts of the two main switches and the two change-over switches are arranged on a rotary shaft, static contacts respectively corresponding to the two main switches and the two change-over switches are connected to taps of corresponding transformers , and the dynamic contacts are connected with coaxial static contacts in the process of rotating along with the rotary shaft; according to the preset time sequence, corresponding main switches, change-over switches, and control switches are controlled to be broken and closed, to realize that the load current is transferred from the originally-closed main switch to the to-be-closed main switch without interruption, and no arc in the breaking and closing process of each of the switches.

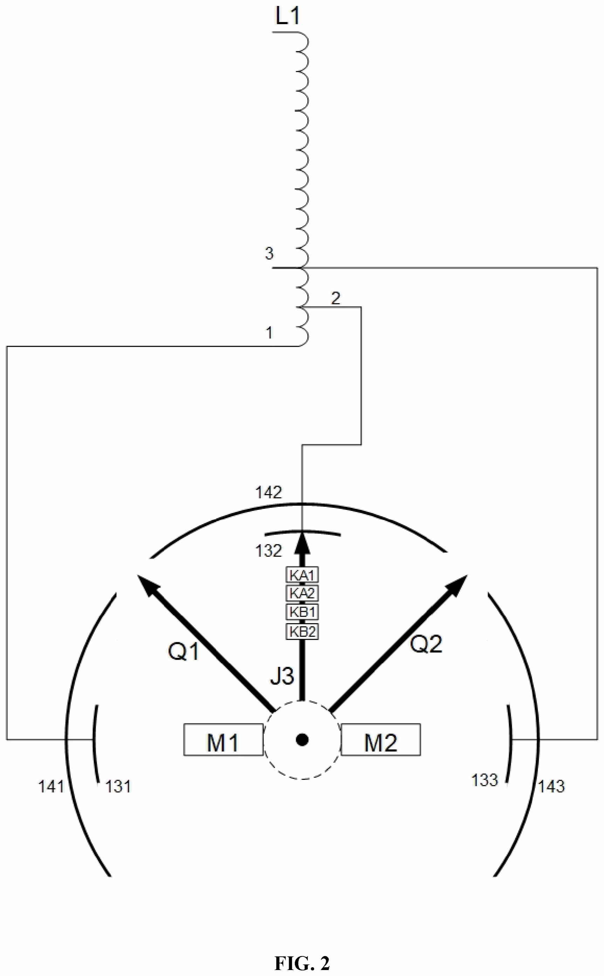

The no-arc on-load tap changer of the present embodiment uses the rotary shaft as power, is suitable for oil-immersed transformers, and the no-arc on-load tap changer is composed of rotating sliding contacts, and a structure thereof is shown in FIG.2. Because the structure of the oil-immersed on-load tap changer is generally three-phase on-load tap changers mounted on an insulated rotary shaft and the three-phase on-load tap changers have the same structure and are driven synchronously by the rotary shaft. For convenience of description, FIG.2 takes a single-phase oil-immersed on-load tap changer with three taps as an example.

In the present embodiment, the control switches are also a rotary-shaft-type switch, and the dynamic contacts of the control switches are also arranged on the rotary shaft.

The static contacts of all the main switches and the change-over switches are divided into at least two groups, each of the two groups of the static contacts is correspondingly mounted on one track, and the tracks corresponding to the two groups take a rotary shaft as the center and are fixed; wherein, the tracks are a circular insulating frame, and does not move along with the rotary shaft. The dynamic contacts are mounted on the rotary shaft and rotate along with the rotary shaft.

Wherein, before the switching of the no-arc on-load tap changer, one end of each of the thyristor auxiliary modules is suspended or connected in parallel with the originally-closed main switch. And, before the switching of the no-arc on-load tap changer, the voltages between both ends of the thyristor auxiliary modules are zero.

In a switching process of the no-arc on-load tap changer, the thyristor auxiliary modules are respectively connected in parallel with the originally-closed main switch or the to-be-closed main switch according to a required time sequence.

The present embodiment takes a number of the groups of the static contacts as two, that is, there are two tracks; each of the groups of the static contacts has three static contacts, and the number of the dynamic contacts is three, as an example.

It can be understood that, in other embodiments, a person skilled in the art can specifically set the number of dynamic contacts and the number of the groups of the static contacts according to actual situations.

In the present embodiment, there are three static contacts on the first track, and the three static contacts are arranged in sequence; the radian of the gap between the center positions of the first and second static contacts on the first track is equal to W , and the radian of the gap between the center positions of the second and third static contacts on the first track is also equal to W ; there are also static contacts on the second track, and the number of static contacts on the second track is equal to the number of static contacts on the first track; the center line of each static contact on the first track correspondingly overlaps with the center line of each static contact on the second track respectively, and the one of the static contacts on the first track and the one of the static contacts on the second track that with overlapped centerlines are connected and further sequentially connected with the tap I, the tap II and the tap III of the transformer coil L1 respectively.

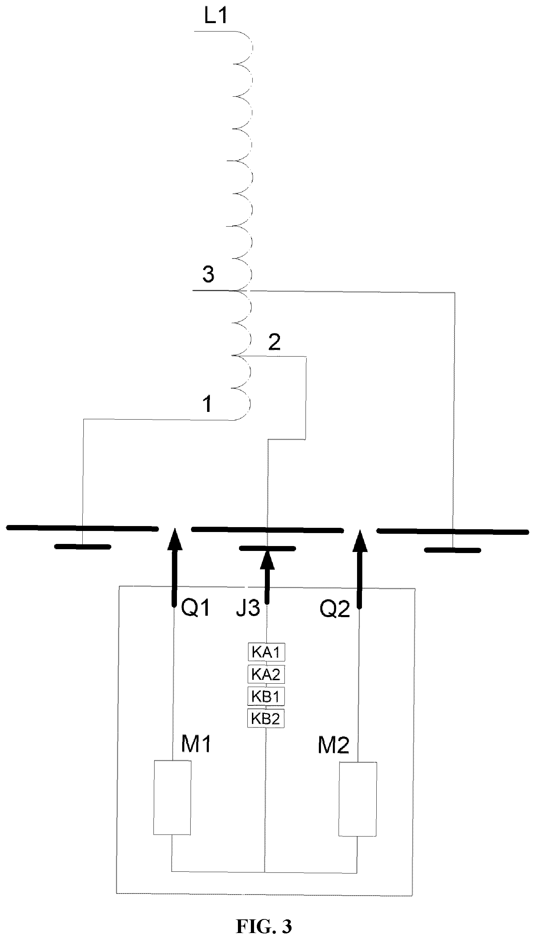

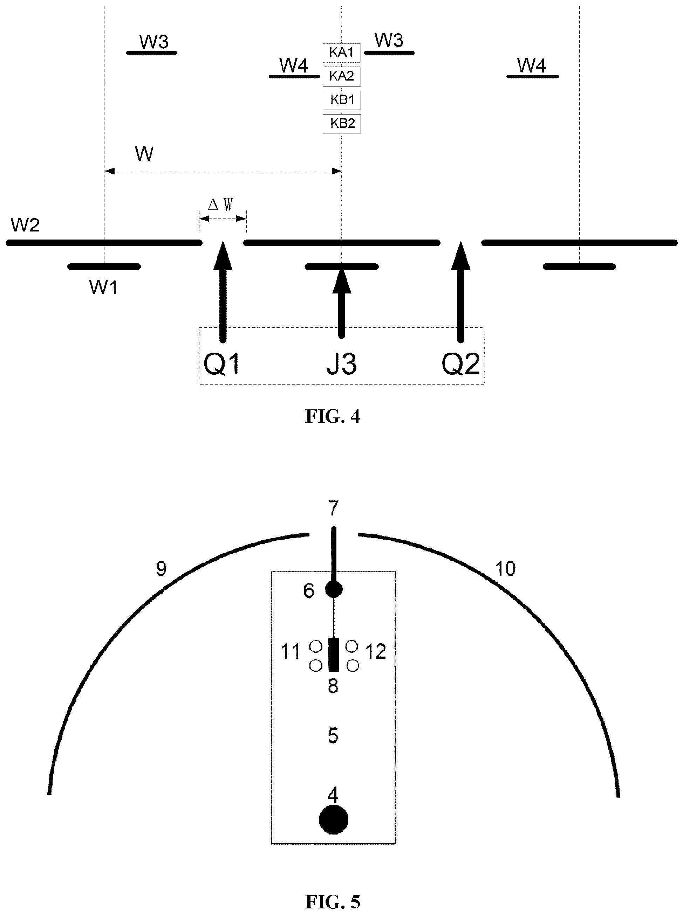

The radians of the three static contacts on the first track are the same, equal to $W1$ ; the radians of the three static contacts on the second track are the same, equal to $W2$; and the radians of the gaps between the static contacts on the second track are the same, equal to $\Delta W = (W - W2)$. For convenience of explanation, the structure diagram of the rotary shaft the no-arc on-load tap changer of FIG.2 is expanded horizontally, as shown in FIGs.3 and 4. Wherein, let: $0 < \Delta W < W1 < 0.5W < W2$.

In the present embodiment, there are three dynamic contacts on the rotary shaft, such as the dynamic contact J3, the dynamic contact Q1 and the dynamic contact Q2; the dynamic contacts are mounted on the rotary shaft to rotate along with the rotary shaft; and the dynamic contact Q1 and the dynamic contact Q2 are respectively arranged on two sides of the dynamic contact J3.

The dynamic contact J3 respectively connected or disconnected with the three static contacts on the first track in turn when rotating along with the rotary shaft, to realize the connection and disconnection of the main switch; when the dynamic contact Q1 and the dynamic contact Q2 respectively connected or disconnected with the three static contacts on the second track in turn when rotating along with the rotary shaft, to realize the conversion of the change-over switch; the center position of the dynamic contact Q1 is on the second track on the left side of the center of the dynamic contact J3, and an included angle there between is 0.5W; the center position of the dynamic contact Q2 is on the second track on the right side of the center of the dynamic contact J3, and an included angle there between is 0.5W.

A normal operating state of the no-arc on-load tap changer of the present embodiment before switching is that: the dynamic contact J3 on the rotary shaft is located on the center line of the static contact W1, and the dynamic contact Q1 and the dynamic contact Q2 are respectively located on the center line of the gaps.

In the present embodiment, the thyristor auxiliary module M1 and the thyristor auxiliary module M2 have same a main circuit, and the main circuit of each of the two thyristor auxiliary modules includes a pair of thyristors connected in reverse parallel; an RC series circuit is connected in parallel at two ends of the reverse-parallel-connected thyristors; a capacitor, a resistor and a diode are sequentially connected between a gate electrode and a cathode of each of the reverse-parallel-connected thyristors; an anode of the diode is connected with the cathode of the corresponding one of the reverse-parallel-connected thyristors, and a cathode of the diode is connected with the gate electrode of the corresponding one of the reverse-parallel-connected thyristors; the gate electrodes of the two the reverse-parallel-connected thyristors are connected in series with one of the two control switches through a full-bridge rectifier circuit; two voltage-stabilizing tubes, a resistor, and another one of the two control switches are connected in series between gate electrodes of the two the reverse-parallel-connected thyristors; wherein the two voltage-stabilizing tubes are connected in reverse series; the two voltage-stabilizing tubes are connected in series with the resistor and then connected with an output end of the full-bridge rectifier circuit; cathodes of the two voltage-stabilizing tubes corresponds to an anode output end of the full-bridge rectifier circuit; and anodes of the two voltage-stabilizing tubes corresponds to a cathode output end of the full-bridge rectifier circuit.

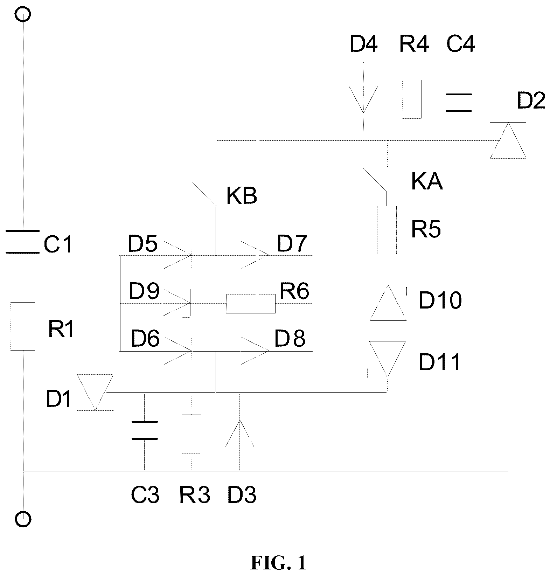

Specifically, as shown in FIG. 1, the main circuit of the each of the thyristor auxiliary modules includes a pair of thyristors D1 and D2 connected in reverse parallel; a resistor R1 connected in series with a capacitor C1 is connected in parallel at both ends of the reverse-parallel-connected thyristors D1 and D2; gates and cathodes of the two thyristors D1 and D2 are respectively connected in parallel with capacitors C3 and C4, resistors R3 and R4, and diodes D3 and D4; wherein, anodes of the diodes D3 and D4 are respectively connected with the cathodes of the thyristors D1 and D2, and cathodes of the diodes D3 and D4 are respectively connected with the gates of the thyristors D1 and D2; voltage-regulator tubes D10 and D11 are connected in reverse series and then connected in series with a resistor R5, and then connected in series with the control switch KA, and then connected between the gate electrodes of the two thyristors D1 and D2. The full-bridge rectifier circuit composed of diodes D5, D6, D7 and D8 is connected between the gate electrodes of the two thyristors D1 and D2 after connecting an input terminal of the full-bridge rectifier circuit in series with the control switch KB, the voltage-regulator tube D9 is connected in series with the resistor R6 and then connected with an output terminal of the full-bridge rectifier circuit, wherein the cathode of the voltage-regulator tube D9 corresponds to the anode output terminal of the full-bridge rectifier circuit, and the anode of the voltage-regulator tube D9 corresponds to the cathode output terminal of the full-bridge rectifier circuit; the stable voltage of voltage regulator tube D9 is $U1 = k1*U2$, wherein $k1$ is the reliability coefficient, taking a value between 1.2 and 2, $U2$ is the peak value of the regulated interval voltage of the voltage regulating transformer. It is suggested that the stable voltage of voltage regulator tubes D10 and D11 should be 1~3 volts.

It should be noted that the specific working process of the thyristor auxiliary module has been disclosed in the Chinese Patent CN108768359A (application No.: 201810290470.4), and will not be repeated here.

In the present embodiment, the thyristor auxiliary module M1 is connected to the control switches KA1 and KB1, and the thyristor auxiliary module M2 is connected to the control switches KA2 and KB2.

The dynamic contact J3 is connected with the public endpoint; two ends of the main circuit of the thyristor auxiliary module M1 are connected with the dynamic contact Q1 and the public endpoint, respectively; and two ends of the main circuit of the thyristor auxiliary module M2 are connected with the dynamic contact Q2 and the public endpoint, respectively.

In the specific implementation process, the control switches KA1 and KA2 are mounted on the rotary shaft, and when the control switches KA1 and KA2 rotate with the rotary shaft, two concentric circles can be drawn respectively, which are respectively called: the third track and the fourth track. A static contact W3 is provided on the third track in a region between the center line of the first static contact on the first track and the center line of the second static contact on the first track, and a static contact W4 is provided on the fourth track in this region. Similarly, the static contacts W3 and W4 repeatedly appear respectively on the third track and the fourth track in a region between the center line of the second static contact on the first track and the center line of the third static contact on the first track, as shown in FIG.4.

When the control switch KA1 rotates with the rotary shaft and meets the static contact W3, the control switch KA1 closes; when it leaves the static contact W3, the control switch KA1 is broken. When the control switch KA2 rotates with the rotary shaft and meets the static contact W4, the control switch KA2 closes; when it leaves the static contact W4, the control switch KA2 is broken. It can be seen that the static contact W3 and the static contact W4 may not necessarily be made of metal materials, they only need to be able to touch the control switch KA1 to close or the control switch KA2 to close.

When the rotary shaft rotates clockwise, before the dynamic contact J3 leaves the static contact W1, the control switch KA1 must contact the static contact W3; after the dynamic contact J3 leaves the static contact W1, the control switch KA1 is allowed to leave the static contact W3; before the dynamic contact J3 contacts another static contact W1, the control switch KA2 must contact the static contact W4; after the dynamic contact J3 contacts another static contact W1, the control switch KA2 is allowed to leave the static contact W4; and, the control switch KA2 is allowed to contact the static contact W4 at least after the time interval $t1$ after the control switch KA1 leaves the static contact W3.

When the rotary shaft rotates counter clockwise, before the dynamic contact J3 leaves the static contact W1, the control switch KA2 must contact the static contact W4; after the dynamic contact J3 leaves the static contact W1, the control switch KA2 is allowed to leave the static contact W4; before the dynamic contact J3 contacts another static contact W1, the control switch KA1 must contact the static contact W3; after the dynamic contact J3 contacts another static contact W1, the control switch KA1 is allowed to leave the static contact W3; and, the control switch KA1 is allowed to contact the static contact W3 at least after the time interval $t1$ after the control switch KA2 leaves the static contact W4.

In order to ensure that the time interval $t1$ is greater than the set time (e.g.0.015 seconds), the rotary shaft should not rotate too fast. If the rotary shaft takes $T$ seconds to make one revolution, then:

$$T > \left( \left( 0.015 \times 2\pi \right) / \left( W2 - W3 - W4 \right) \right),$$

wherein, $W2$ is the radian of each the static contact on the second track, $W3$ and $W4$ are the radians of each static contact on the third track and the radians of each static contact on the fourth track respectively.

In the present embodiment, there is also a control mechanism on the rotary shaft. When the rotary shaft rotates clockwise and before the KA1 leaves the static contact W3, the control mechanism must open the control switch KB1 and close the control switch KB2. When the rotary shaft rotates counterclockwise and before the KA2 leaves the static contact W3, the control mechanism must close the control switch KB1 and open the control switch KB2.

The principle of the switching control of the no-arc on-load tap changer of the present embodiment is as follows:

> controlling the rotation of the rotary shaft to drive the dynamic contacts to be connected with or detached from the corresponding static contacts; and
> controlling corresponding main switches, changeover switches, and control switch to be broken and closed according to the preset time sequence, to realize that the load current is transferred from an originally-closed main switch to a to-be-closed main switch without interruption, and no arc in the breaking and closing processes of each of the switches.

Wherein, a rotation mode of the rotation of the rotary shaft includes a clockwise rotation and a counterclockwise rotation.

A one-time switching process of main switch of the present embodiment includes:

dynamic contacts of corresponding one of the two change-over switches contact with corresponding static contacts to close a first control switch of the thyristor auxiliary module connected with the originally-closed main switch, and breaking the originally-closed main switch;
closing a second control switch of the thyristor auxiliary module connected to the to-be-closed main switch and breaking the first control switch of the thyristor auxiliary module connected to the originally-closed main switch;
after a set time interval, closing a first control switch of the thyristor auxiliary module connected with the to-be-closed main switch, and closing the to-be-closed main switch; and
breaking all the control switches , and the dynamic contacts of the corresponding one of the two change-over switches are detached from the corresponding static contacts to complete the one-time switching of main switch.

Referring to FIG.2, the one-time switching process of main switch in the present embodiment is as follows:

(1) contacting the dynamic contacts Q1 and Q2 respectively with the two static contacts W2; closing the control switch KA of the thyristor auxiliary module connected in parallel with the originally-closed main switch;
(2) breaking the originally-closed main switch;
(3) closing the control switch KB of another thyristor auxiliary module connected in parallel with the to-be-closed main switch;
(4) breaking the control switch KA of the thyristor auxiliary module connected in parallel with the originally-closed main switch;
(5) after the time interval $t$1 (wherein, the time interval $t$1 is greater than 0.015 seconds), closing the control switch KA of the thyristor auxiliary module in parallel with the to-be-closed main switch over a;
(6) closing the to-be-closed main switch;
(7) breaking all the control switches of the thyristor auxiliary modules;
(8) detaching the dynamic contacts Q1 and Q2 from the static contacts W2; and
(9) completing the one-time switching of main switch.

Referring to FIG.2, the one-time switching process of main switch of the present embodiment is described by rotating the rotary shaft clockwise and counterclockwise respectively.

The switching control process when the no-arc on-load tap changer of the present embodiment rotates clockwise is as follows:

(1) the dynamic contact J3 rotates clockwise from the center line position of the static contact W1 that has been contacted, the dynamic contact Q1 contacts the static contact W2 connected to the static contact W1 that has been contacted by the dynamic contact J3, and the dynamic contact Q2 contacts the static contact W2 connected to the static contact W1 that will be contacted by the dynamic contact J3. The control switch KA1 of the thyristor auxiliary module M1 contacts the static contact W3, and the control switch KA1 closes. The flow path of the load current is unchanged, and still from the static contact W1 that has been contacted by the dynamic contact J3 flows into the public endpoint through the dynamic contact J3;
(2) the dynamic contact J3 is detached from the static contact W1; the load current flows into the public endpoint from the static contact W2 connected with the original static contact W1, the dynamic contact Q1, and the thyristor auxiliary module M1;
(3) the control switch KB2 of the thyristor auxiliary module M2 closes; the circulation path of the load current remains unchanged;
(4) the control switch KA1 of the thyristor auxiliary module M1 is detached from the static contact W3, and the control switch KA1 is broken. Each zero crossing point of the load current contacts the thyristor auxiliary module M2 once, so that the load current flows into the public endpoint from the static contact W2 connected by the static contact W1 to be contacted, the dynamic contact Q2 and the thyristor auxiliary module M2;
(5) after the time interval $t$1, the control switch KA2 of the thyristor auxiliary module M2 contacts the static contact W4, and the control switch KA2 closes; the circulation path of the load current remains unchanged;
(6) the dynamic contact J3 contacts the static contact W1 to be contacted; the load current flows from the static contact W1 contacted by the dynamic contact J3, through the dynamic contact J3, into the public endpoint;
(7) the dynamic contacts Q1 and Q2 are detached from the static contacts W2; the control switch KA2 of the thyristor auxiliary module M2 is detached from the static contact W4, the control switch KA2 is broken; the control switch KB2 of the thyristor auxiliary module M2 is broken; and
(8) the dynamic contact J3 rotates to the center line position of the static contact W1 newly contacted and stops rotating; the one-time switching of main switch is completed. The time interval $t$1 is greater than 0.015 seconds.

The switching control process when the no-arc on-load tap changer of the present embodiment rotates counterclockwise is as follows:

(1) the dynamic contact J3 starts to rotate counterclockwise from the center line position of the static contact W1 that has been contacted. The dynamic contact Q2 contacts the static contact W2 connected to the static contact W1 that has been contacted by the dynamic contact J3, and the dynamic contact Q1 contacts the static contact W2 connected to the static contact W1 that will be contacted by the dynamic contact J3. The control switch KA2 of the thyristor auxiliary module M2 contacts the static contact W4, and the control switch KA2 closes. The flow path of the load current is unchanged, and still from the static contact W1 that has been contacted by the dynamic contact J3 flows into the public endpoint through the dynamic contact J3;

(2) the dynamic contact J3 is detached from the static contact W1; The load current flows into the public endpoint from the static contact W2 connected with the original static contact W1, the dynamic contact Q2, and the thyristor auxiliary module M2;

(3) the control switch KB2 of the thyristor auxiliary module M1 closes; the circulation path of the load current remains unchanged;

(4) the control switch KA2 of the thyristor auxiliary module M2 is detached from W4, and the control switch KA2 is broken. Each zero crossing point of the load current contacts the thyristor auxiliary module M1 once, so that the load current flows into the public endpoint from the static contact W2 connected by the static contact W1 to be contacted, the dynamic contact Q1 and the thyristor auxiliary module M1;

(5) after the time interval $t1$, the control switch KA1 of the thyristor auxiliary module M1 contacts the static contact W3, and the control switch KA1 closes; the circulation path of the load current remains unchanged;

(6) the dynamic contact J3 contacts the static contact W1 to be contacted; the load current flows from the static contact W1 contacted by the dynamic contact J3, through the dynamic contact J3, into the public endpoint;

(7) the dynamic contacts Q1 and Q2 are detached from the static contacts W2; the control switch KA1 of the thyristor auxiliary module M1 is detached from the static contact W3, the control switch KA1 is broken; the control switch KB1 of the thyristor auxiliary module M1 is broken; and

(8) the dynamic contact J3 rotates to the center line position of the static contact W1 newly contacted and stops rotating; the one-time switching of main switch is completed.

Both the no-arc on-load tap changer of the present embodiment and the existing oil-immersed on-load tap changer use a rotary shaft as driving power, and various switches and contacts can be operated in the oil tank of the oil-immersed transformer. Therefore, the no-arc on-load tap changer of the present invention can be reformed on the basis of the basic structure of the existing oil-immersed on-load tap changer.

The driving force of the existing oil-immersed on-load tap changer comes from an AC motor. In order to prevent the switch switching process from being interrupted due to power loss, the existing on-load tap changer has a spring release mechanism, and if the switch switching process loses power, the spring release mechanism can ensure that the on-load tap changer has a complete switching process. However, the spring energy storage time is longer, and the spring energy storage is carried out only after receiving the switching instruction, and the complete switching process of the existing on-load tap changer is longer. The structure of spring energy storage mechanism and spring energy release mechanism of on-load tap changer is complex, the operation vibration is large, and the failure rate is high.

The no-arc on-load tap changer of the present embodiment can be driven by a DC motor and electrically stored, and the no-arc on-load tap changer can eliminate the spring energy storage mechanism and the spring energy release mechanism.

It should be noted here that the driving motor of the oil-immersed on-load tap changer of the present embodiment may be a DC motor. AC power supply originally supplying power to AC motor supplies power to DC motor through bridge rectifier circuit and voltage stabilizing circuit, output of bridge rectifier circuit is connected in parallel with capacitor energy storage circuit, and stored electric energy of capacitor energy storage circuit can at least provide on-load tap changer to complete one complete operation. The electrical energy storage can be performed before the switching command is received, so that the time of a complete switching process of the no-arc on-load tap changer of the present embodiment is relatively short. Thus, the spring energy storage mechanism and the spring energy release mechanism of the no-arc on-load tap changer of the present embodiment can be eliminated.

The no-arc on-load tap changer of the present embodiment cancels the transition resistance, and there is no heating device in the switching process. In this way, the switching process does not have to have a fast mechanism (ensuring that the transition resistance is energized for no more than 40 milliseconds) as in the existing on-load tap changer. The switching process of the no-arc on-load tap changer of the present embodiment can be completed in tens of seconds. Therefore, the no-arc on-load tap changer of the present invention can be reformed on the basis of the basic structure of the existing oil-immersed non-excitation tap changer.

The no-arc on-load tap changer of the present embodiment has simple structure, small operation vibration and low failure rate. The no-arc on-load tap changer with the structure shown in FIG.2 is a compound no-arc on-load tap changer. The compound no-arc on-load tap changer mixes the selector and the switcher together, simplifies the on-load tap changer structure, and has low cost; however, it can only be used in situations where the selector is relatively simple. If the on-load tap changer selector is complex and is not suitable for making a composite on-load tap changer, a combined structure of a selector and a switch in series can be adopted. Reducing the first track static contact of the structure of FIG.2 to two is actually a switch structure. By connecting the switch with this structure in series with the existing selector, a combined no-arc on-load tap changer can be constructed.

Embodiment 2

The present embodiment provides a no-arc on-load tap changer, and a structure thereof is the same as that of Embodiment 1. The difference is that in the present embodiment, a mechanical linkage mechanism is used to control the control switches KB1 and KB2.

As shown in FIG.5, the mechanical linkage mechanism of the present embodiment includes a deflection shaft 6, wherein the deflection shaft 6 is fixed on a rotary shaft 4 and rotates along with the rotary shaft 4; a lever arm 7 and a spring arm 8 which can rotate around the deflection shaft 6 are mounted on the deflection shaft 6; a first end of the spring arm 8 is provided with a contact, and the contact contacts with or detachs from the corresponding control switch along with the rotation of the rotary shaft 4, so that the corresponding control switch is broken and closed.

Wherein, the working process of the mechanical linkage mechanism of the present embodiment is as follows:

the rotary shaft 4 can drive a fixed plate 5 to rotate, the fixed plate 5 is further provided with the deflection shaft 6, the deflection shaft is provided with the lever arm 7 and the spring arm 8, the lever arm 7 and the spring arm 8 can rotate around the deflection shaft 6, and the first end of the spring arm 8 is provided with the contact; a circular hoop with the rotary shaft 4 as the center is provided on a stationary insulating frame, gaps on the circular hoop at positions of center lines of the static contacts W1 divide the circular hoop into several sections, and a number of the gaps on the circular hoop correspond to the number of static contacts W1; for example, three static contacts W1 correspond to three the gaps on the circular hoop, and the three gaps divide the circular hoop into a first circular hoop 9 and a second circular hoop 10; and the normal operation state before the switching of the first-type no-arc on-load tap changer is: the lever arm 7 is positioned on a center line of one the gap of the circular hoop.

When the rotary shaft 4 rotates clockwise, the lever arm 7 encounters the second circular hoop 10, the second circular hoop 10 pushes the lever arm 7 to rotate counterclockwise around the deflection shaft 6, the lever arm 7 drives the spring arm 8 to rotate counterclockwise, the contact on the spring arm 8 contacts the contact of the switch KB2, and the switch KB2 closes. Until the lever arm 7 leaves the second hoop 10 and encounters another gap, the lever arm 7 returns to the center line of the gap; the spring arm 8 also returns to the center line of the gap, the contact on the spring arm 8 leaves the contact of the switch KB2, and the switch KB2 is broken.

When the rotary shaft 4 rotates counterclockwise, the lever arm 7 encounters the first circular hoop 9, the first circular hoop 9 pushes the lever arm 7 to rotate clockwise around the deflection shaft 6, the lever arm 7 drives the spring arm 8 to rotate clockwise, the contact on the spring arm 8 contacts the contact of the switch KB1, and the switch KB1 closes. Until the lever arm 7 leaves the first circular hoop 9 and encounters another gap, the lever arm 7 returns to the center line of the gap, the spring arm 8 also returns to the center line of the gap, the contact on the spring arm 8 leaves the contact of the switch KB1, and the switch KB 1 is broken.

It can be understood here that a person skilled in the art can specifically design the structure of the mechanical linkage mechanism according to the actual situation, which is not described in detail here.

It should be noted that the switching control process of the no-arc on-load tap changer of the present embodiment is the same as the switching control process of the no-arc on-load tap changer of Embodiment 1, and is not repeated here.

Embodiment 3

The present embodiment provides a no-arc on-load tap changer, and a structure thereof is the same as that of Embodiment 1. The difference is that the control means for controlling the control switches KB1 and KB2 in the present embodiment is realized by driving change-over switches by the rotary shaft.

In *"Electrical Mechanism of On-Load Tap Changer "*, edited by Zhu Yinghao et al., published by China Electric Power Press, 2012, p63-66, it has introduced that a change-over switch MTF driven by rotary shaft can constitute the control switches KB1 and KB2. Four static contacts of the change-over switch MTF in this book are MTF1, MTF2, MTF3 and MTF4 respectively; and, the change-over switch can be switched between two states: (1) the first contact and the third contact are conductive, and the second contact and the fourth contact are disconnected;(2) the first contact and the third contact are disconnected, and the second contact and the fourth contact are conductive. Contacts MTF1 and MTF3 can be used as both ends of control switch KB1, respectively; and contacts MTF2, MTF4 can be used as both ends of control switch KB2, respectively.

It should be pointed out that the change-over switch MTF introduced in *"Electrical Mechanism of On-load Tap Changer"* is a switch for high current, and the control switches KB 1 and KB2 are the switches for small current. Therefore, it is necessary to reduce the size according to the working principle of change-over switch MTF to realize the function of control switches KB1 and KB2. Detailed analysis, no longer repeated here.

It should be noted that the switching control process of the no-arc on-load tap changer of the present embodiment is the same as the switching control process of the no-arc on-load tap changer of Embodiment 1, and is not repeated here.

Embodiment 4

FIG.2 shows a no-arc on-load tap changer, wherein the radians of the static contacts are relatively large and the radians of the dynamic contacts are relatively small. It can be seen that the size of the radians of the contacts is to control the length of time and contact sequence that the static contacts contact the dynamic contacts.

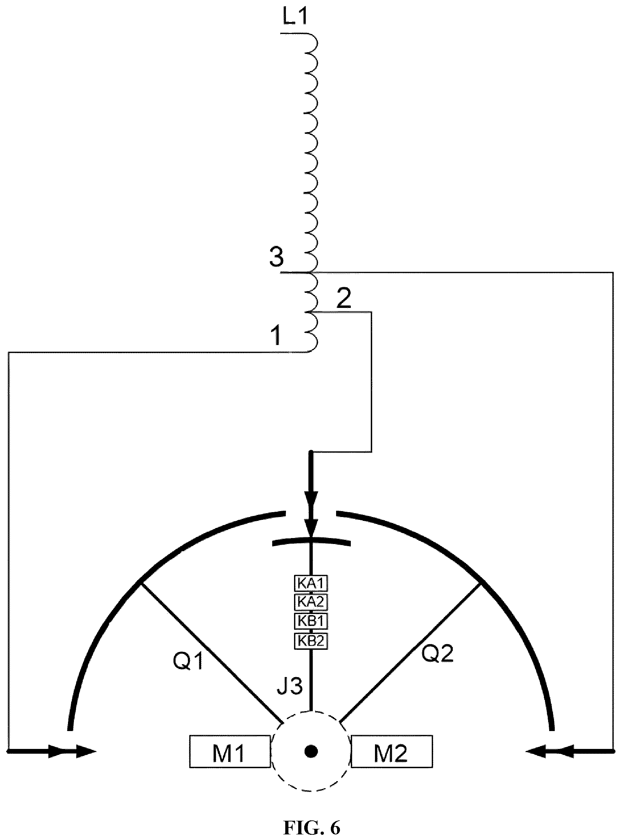

The difference between the present embodiment and Embodiment 1 is that the radians of the static contacts are reduced and the radians of the dynamic contacts are increased, as shown in FIG.6.

The structure of the rotary shaft of the no-arc on-load tap changer of the present embodiment is shown in FIG.6. In the present embodiment, there are three static contacts on the first track, and the three static contacts are arranged in sequence; the radian of the gap between the center positions of the first and second static contacts on the first track is equal to W , and the radian of the gap between the center positions of the second and third static contacts on the first track is also equal to W ; there are also static contacts on the second track, and the number of the static contacts on the second track is equal to the number of the static contacts on the first track; the center line of each of the static contacts on the first track overlaps with the center line of each of the static contacts on the second track respectively, and the one of the static contacts on the first track and the one of the static contacts on the second track that with the overlapped center line are connected and further connected with three taps of the transformer coil L1 respectively in turn.

The rotary shaft of the embodiment is provided with at least three dynamic contacts: the dynamic contact J3, the dynamic contact Q1 and the dynamic contact Q2; the dynamic contacts are mounted on the rotary shaft and rotates along with the rotary shaft; when the dynamic contact J3 rotates along with the rotary shaft, the dynamic contact J3 is respectively connected with the three static contacts on the first track in sequence; when the dynamic contact Q1 and the dynamic contact Q2 rotate along with the rotary shaft, the dynamic contact Q1 and the dynamic contact Q2 are respectively connected with the three static contacts on the second track in sequence; the center position of the dynamic contact Q1 is on the second track on the left side of the center position of the dynamic contact J3, and the included angle between two the center positions is $0.5W$ ; and the center position of the dynamic contact Q2 is on the second track on the right side of the center position of the dynamic contact J3, and the included angle between two the center positions is $0.5W$.

The radian of the contact of the dynamic contact J3 is $W_{1dyamic}$, the radians of the contacts of the dynamic contact Q1 and the dynamic contact Q2 are $W_{2dynamic}$, and the radian of the gap between the dynamic contact Q1 and the dynamic contact Q2 is $\Delta W_{dynamic} = (W - W_{2dynamic})$. Let: $0 < \Delta W < W_{1dynamic} < 0.5W < W_{2dynamic}$, as shown in FIG.6; wherein, $W$ is the radian between the center positions of each of the static contacts on the first track.

It should also be noted that the breaking and closing of the control switches in the present embodiment is controlled by the control mechanism. The control mechanism may be implemented by using the second embodiment or the third embodiment or other existing control mechanisms, and a person skilled in the art may specifically select the control mechanism according to the actual situation, which is not repeated here.

The switching control method of the no-arc on-load tap changer of the present embodiment is the same as that of the no-arc on-load tap changer of Embodiment 1, and is not repeated here. The no-arc on-load tap changer of the present embodiment has the same contents as the no-arc on-load tap changer of Embodiment 1, and is not repeated here.

By comparing FIG.2 with FIG.6, the radians of the static contacts of the first track and the second track of the no-arc on-load tap changer of the present embodiment are relatively small, and the radians of the dynamic contacts are relatively large; because there are only three dynamic contacts, the number of static contacts may be large, so the manufacturing cost of the no-arc on-load tap changer of the present embodiment is lower than that of the no-arc on-load tap changer of Embodiment 1

Embodiment 5

The present embodiment provides a no-arc on-load tap changer, which include sat least two main switches, two change-over switches and two thyristor auxiliary modules; wherein, each of the two thyristor auxiliary modules includes two control switches; the two main switches comprise an originally-closed main switch and a to-be-closed main switch; the two main switches are connected in corresponding loops of a voltage regulating coil through corresponding transformer taps; the two thyristor auxiliary modules are connected with the originally-closed main switch or the to-be-closed main switch according to a required time sequence during the switching of main switch; and

the two main switches and the two change-over switches are all rotary-shaft-type switches, wherein the two main switches and corresponding one of the two change-over switches are linked and synchronously rotated, respectively; corresponding main switches, change-over switches, and control switches are controlled to be broken and closed according to the preset time sequence, to realize that the load current is transferred from the originally-closed main switch to the to-be-closed main switch without interruption, and no arc in the breaking and closing process of each of the switches.

It should be noted here that the control mechanism is a mechanical linkage mechanism and the structure thereof may adopt the specific structure of the mechanical linkage mechanism described in Embodiment 2, or may adopt the control mechanism described in Embodiment 3. Those skilled in the art can make specific settings according to actual conditions, and will not be described here.

In the present embodiment, the structures of the two thyristor auxiliary modules are the same, and the specific structure thereof is shown in FIG. 1, and the specific description is the same as that of Embodiment 1, so it is not repeated here.

The switching control method of the no-arc on-load tap changer of the present embodiment includes:

controlling breakings and closings of the corresponding main switches and change-over switches by linking and synchronously rotating; and
controlling corresponding main switches, change-over switches, and control switch to be broken and closed according to the preset time sequence, to realize that the load current is transferred from an originally-closed main switch to a to-be-closed main switch without interruption, and no arc in the breaking and closing processes of each of the switches.

<Electrical accessory>

In one or more embodiments, providing an electric accessory, according to claim 10.

The transformer in the present embodiment is an oil-immersed transformer or a transformer with an oil-immersed vacuum on-load tap changer.

The electric accessory can be constructed in any manner according to requirements, for example as a compensation choke for influencing reactive power in an alternating power grid or as a local power grid transformer or power transformer or adjustable transformer or phase-shifting transformer or rectifier transformer or reactive power compensation device; and/or configured such that the device includes at least one or no additional regulating winding and/or at least one or no additional no-arc on-load tap changer and/or at least one mains winding.

**Claims**

1. A no-arc on-load tap changer, comprising at least one main switch (J3), a first change-over switch (Q1), a second change-over switch (Q2), a first thyristor auxiliary module (M1) and a second thyristor auxiliary module (M2); wherein, the first thyristor auxiliary module (M1) comprises two control switches (KA1, KB1), and the second thyristor auxiliary module (M2) comprises two control switches (KA2, KB2); first static contacts (131, 132, 133) are connected to corresponding taps (1, 2, 3) on a voltage regulating coil of a transformer (L1); wherein

the main switch (J3) and the first and second change-over switches (Q1, Q2) are all rotary-shaft-type switches and arranged on a rotary shaft (4);
the main switch (J3) comprises a third dynamic contact (J3); the first and second change-over switches comprise a first dynamic contact (Q1) and a second dynamic contact (Q2), respectively;
switch-on positions of the main switch are positions that the third dynamic contact (J3) contacts the first static contacts (131, 132, 133) respectively; second static contacts (141, 142, 143) that are able to contact to the first and second dynamic contacts (Q1, Q2) are connected to the first static contacts (131, 132, 133), correspondingly, and further are connected to the corresponding taps (1, 2, 3) of the transformer (L1), respectively; such that
in a process of clockwise or counterclockwise rotation of the rotating shaft (4), the third static contact (J3) of the main switch is able to contact or be separated from the first static contact (131, 132, or 133) according to a preset time sequence of switch; the first and second dynamic contacts (Q1, Q2) are able to contact or be separated from the second static contacts (141, 142, or 143) according to the preset time sequence of switch;
the first dynamic contact (Q1) and the second dynamic contact (Q2) are respectively arranged on two sides of the third dynamic contact (J3); a center position of the first dynamic contact (Q1) is on the left side of a center of the third dynamic contact (J3), and a radian of an included angle therebetween is 0.5W; a center position of the second dynamic contact (Q2) is on the right side of the center of the third dynamic contact (J3), and a radian of an included angle therebetween is 0.5W; wherein, W is a radian of an included angle between center positions of each two (131 and 132; or, 132 and 133) of the first static contacts;
the first thyristor auxiliary module (M1) and the second thyristor auxiliary module (M2) are configure to have the same structure; the third dynamic contact (J3) is for connecting to a public endpoint;
two ends of a main circuit of the first thyristor auxiliary module (M1) are connecting to the first dynamic contact (Q1) and for connecting to the public endpoint, respectively; and two ends of a main circuit of the second thyristor auxiliary module (M2) are connecting to the second dynamic contact (Q2) and for connecting to the public endpoint, respectively; and

a dynamic contact of each of the control switches (KA1, KB1, KA2, KB2) is arranged on the rotary shaft (4) and configured to rotate with the rotary shaft (4); wherein, in the rotating process of the rotating shaft (4), the closing and opening of the control switches (KA1, KB1, KA2, KB2) are triggered when the dynamic contacts of the control switches (KA1, KB1, KA2, KB2) contact or are separated from third and fourth static contacts (W3, W4), and first and second trigger contacts (11, 12).

2. The no-arc on-load tap changer according to claim 1, wherein during the rotation process of the rotary shaft (4), the closing and the opening of a first control switch (KA1) of the first thyristor auxiliary module (M1) is triggered by the dynamic contact (KA1) of the first control switch (KA1) of the first thyristor auxiliary module (M1) passing through a series of arc-shaped sections of the third static contact (W3); the closing and the opening of a first control switch (KA2) of the second thyristor auxiliary module (M2) is triggered by the dynamic contact of the first control switch (KA2) of the second thyristor auxiliary module (M2) passing through a series of arc-shaped sections of the fourth static contact (W4); the closing and the opening of a second control switch (KB1) of the first thyristor auxiliary module (M1) are triggered through a fourth dynamic contact (8) contacts or is separated from a first trigger contact (11); and, the closing and the opening of a second control switch (KB2) of the second thyristor auxiliary module (M2) are triggered through the fourth dynamic contact (8) contacts or is separated from a second trigger contact (12).

3. The no-arc on-load tap changer according to claim 1, wherein the first static contact (131, 132, 133) are mounted on a first arc-shaped track centered on the rotation axis at equal arc distances and fixedly;

the second static contacts (141, 142, 143) are mounted on a second arc-shaped track centered on the rotary shaft (4) at equal arc distances and fixedly; and the first static contacts (131, 132, 133) correspond to the second static contacts (141, 142, 143) in pairs and center line positions thereof coincide in each of the pairs; wherein, relationships among arc lengths of all the static contacts (131, 132, 133, 141, 142, 143) are as follows:

$$0 < \Delta W < W1 < 0.5W < W2,$$

$$\Delta W = (W - W2),$$

wherein: $W1$ is an arc length of the first static contact (131, 132, 133); $W2$ is an arc length of the second static contacts (141, 142, 143); $W$ is an arc distance between the center line positions of two adjacent first static contacts; and, $\Delta W$ is an arc distance of a gap between two adjacent second static contacts;.

4. The no-arc on-load tap changer according to claim 1, wherein before the switching process of main switch, a normal operating state of the no-arc on-load tap changer, comprising:
in a state where the third dynamic contact (J3) is located on a center line of the first static contact (132), the first and second dynamic contacts are respectively located on center lines of gaps between two adjacent second static contacts.

5. The no-arc on-load tap changer according to claim 1, wherein the closing and the opening of the control switches (KB1, KB2) are controlled by the control mechanism; wherein
the control mechanism is a mechanical linkage mechanism, comprising:

a deflection shaft (6), the deflection shaft (6) is fixed on the rotary shaft (4) and rotates along with the rotary shaft (4), a lever arm (7) and a spring arm (8) rotating around the deflection shaft (6) are mounted on the deflection shaft (6), one end of the spring arm (8) is provided with a fourth dynamic contact, and the fourth dynamic contact rotates along with the rotary shaft (4) to contact with or be separated from corresponding one of contacts (11, 12), make the corresponding one of the control switches (KB1, KB2) open or close, respectively; optionally, a control means for the control mechanism is realized by driving the change-over switches on the rotary shaft (4).

6. The no-arc on-load tap changer according to claim 1, wherein each one of the first and second thyristor auxiliary modules (M1, M2) comprises:

a pair of thyristors (D1, D2) connected in reverse parallel;
an RC series circuit (R1 and C1) is connected in parallel at two ends of the pair of the thyristors (D1, D2);
a capacitor (C3, C4), a resistor (R3, R4) and a diode (D3, D4) are sequentially connected between a gate electrode and a cathode of each of the pair of the thyristors (D1, D2); wherein an anode of the diode (D3, D4) is connected with a cathode of corresponding one (D1, D2) of the pair of the thyristors, and a cathode of the diode (D3, D4) is connected with a gate electrode of the corresponding one (D1, D2) of the pair of the thyristors;
the gate electrodes of the pair of the thyristors (D1, D2) are connected in series with one (KB) of the two control switches through a full-bridge rectifier circuit; a first voltage-stabilizing tube (D10), a second voltage-stabilizing tube (D11), a resistor (R5), and another one (KA) of the two control switches are connected in series between the gate electrodes of the pair of the thyristors (D1, D2); wherein the first and second voltage-stabilizing tubes (D10, D11) are connected in reverse series;
a third voltage-stabilizing tube (D9) is connected in series with a resistor (R6) and then connected with an output end of the full-bridge rectifier circuit, wherein
a cathode of the third voltage-stabilizing tube (D9) is connected to an anode output end of the full-bridge rectifier circuit, and an anode of the third voltage-stabilizing tube (D9) is connected to a cathode output end of the full-bridge rectifier circuit.

7. A switching control method for the no-arc on-load tap changer according to any one of claims 1 to 6, and the switching control method comprising:

rotating the rotary shaft (4) to drive the dynamic contacts (J3, Q1, Q2) to contact or be separated from corresponding ones of the static contacts (131, 132, 133, 141, 142, 143) according to the preset time sequence of switch; simultaneously, the rotation of the rotary shaft (4) drives the dynamic contacts of the control switches (KA1, KB1, KA2, KB2) to contact or be separated from the third and fourth static contacts (W3, W4), and the first and second trigger contacts (11, 12), to trigger the closing and opening of the control switches (KA1, KB1, KA2, KB2); during the rotation of the rotary shaft (4), a load current is transferred from a current switch-on position of the main switch (J3) to a next switch-on position of the main switch (J3) without interruption, and no arc in the breaking and closing processes of all the switches.

8. The switching control method for the no-arc on-load tap changer according to claim 7, wherein a rotation mode of the rotation of the rotary shaft (4) comprises a clockwise rotation; wherein a process of one-time switching of the main switch (J3), comprising:

when the rotary shaft (4) starts rotating clockwise,
the third dynamic contact (J3) starts moving from the center line position of the first static contact (131 or 132) which the third dynamic contact (J3) currently contacts with, the first dynamic contact (Q1) contacts the second static contact (141 or 142) connected correspondingly to the first static contact (131 or 132) being contacted currently by the third dynamic contact (J3), the second dynamic contact (Q2) contacts the second static contact (142 or 143) connected correspondingly to the first static contact (132 or 133) to be contacted by the third dynamic contact (J3);
closing a first control switch (KA1) of the first thyristor auxiliary module (M1) connected between the main switch (J3) and the first change-over switch (Q1);
then, the third dynamic contact (J3) is disengaged from the first static contact (131 or 132), closing a second control switch (KB2) of the second thyristor auxiliary module (M2) connected between the main switch (J3) and the second change-over switch (Q2); simultaneously, breaking the first control switch (KA1) of the first thyristor auxiliary module (M1);
after a set time interval "t1", closing a first control switch (KA2) of the second thyristor auxiliary module (M2); the third dynamic contact (J3) moves to and contacts with the first static contact (132 or 133) located in the next switch-on position of the third dynamic contact (J3);
then, the first and second dynamic contacts (Q1, Q2) are disengaged from the second static contacts (141/142 or 142/143), breaking the first control switch (KA2) of the second thyristor auxiliary module (M2); breaking the second control switch (KB2) of the second thyristor auxiliary module (M2);
when the third dynamic contact (J3) reaches the center line position of the next-contacted first static contact (132 or 133), stopping the rotation of the rotary shaft (4), to complete the one-time switching of the main switch (J3);
or, before the switching of the main switch (J3), the voltages between the two ends of the first and second thyristor auxiliary modules (M1, M2) are zero.

9. The switching control method for the no-arc on-load tap changer according to claim 7, wherein a rotation mode of the rotation of the rotary shaft (4) comprises a counterclockwise rotation; wherein a process of one-time switching of the main switch, comprising:

when the rotary shaft (4) starts rotating counterclockwise,

the third dynamic contact (J3) starts moving from the center line position of the first static contact (133 or 132) which the third dynamic contact (J3) currently contacts with, the second dynamic contact (Q2) contacts the second static contact (143 or 142) connected correspondingly to the first static contact (133 or 132) being contacted currently by the third dynamic contact (J3), the first dynamic contact (Q1) contacts the second static contact (142 or 141) connected correspondingly to the first static contact (132 or 131) to be contacted by the third dynamic contact (J3);

closing a first control switch (KA2) of the second thyristor auxiliary module (M2) connected between the main switch (J3) and the second change-over switch (Q2);

then, the third dynamic contact (J3) is disengaged from the first static contact (133 or 132), closing a second control switch (KB1) of the first thyristor auxiliary module (M1) connected between the main switch (J3) and the first change-over switch (Q1); simultaneously, breaking the first control switch (KA2) of the second thyristor auxiliary module (M2);

after a set time interval "t1", closing a first control switch (KA1) of the first thyristor auxiliary module (M1); the third dynamic contact (J3) moves to and contacts with the first static contact (132 or 131) located in the next switch-on position of the third dynamic contact (J3);

then, the second and first dynamic contacts (Q2, Q1) are disengaged from the second static contacts (143/142 or 142/141), breaking the first control switch (KA1) of the first thyristor auxiliary module (M1); breaking the second control switch (KB1) of the first thyristor auxiliary module (M1);

when the third dynamic contact (J3) reaches the center line position of the next-contacted first static contact (132 or 131), stopping the rotation of the rotary shaft (4), to complete the one-time switching of the main switch (J3);

or, before the switching of the main switch (J3), the voltages between the two ends of the first and second thyristor auxiliary modules (M1, M2) are zero.

10. An electric accessory, comprising:

   a voltage regulating coil (L1), including a plurality of taps (1,2,3) of a transformer; and
   a no-arc on-load tap changer, being connected to the voltage regulating coil (L1);
   wherein, the no-arc on-load tap changer is of any one of the claims 1 to 6.

**Patentansprüche**

1. Lichtbogenfreier Laststufenschalter, umfassend mindestens einen Hauptschalter (J3), einen ersten Umschalter (Q1), einen zweiten Umschalter (Q2), ein erstes Thyristor-Hilfsmodul (M1) und ein zweites Thyristor-Hilfsmodul (M2); wobei das erste Thyristor-Hilfsmodul (M1) zwei Steuerschalter (KA1, KB1) umfasst und das zweite Thyristor-Hilfsmodul (M2) zwei Steuerschalter (KA2, KB2) umfasst; wobei erste statische Kontakte (131, 132, 133) mit entsprechenden Anzapfungen (1, 2, 3) an einer Spannungsregelwicklung eines Transformators (L1) verbunden sind; wobei

   der Hauptschalter (J3) sowie der erste und zweite Umschalter (Q1, Q2) allesamt Drehwellenschalter sind und auf einer Drehwelle (4) angeordnet sind;
   der Hauptschalter (J3) einen dritten dynamischen Kontakt (J3) umfasst; der erste und zweite Umschalter jeweils einen ersten dynamischen Kontakt (Q1) und einen zweiten dynamischen Kontakt (Q2) umfassen;
   wobei Einschaltpositionen des Hauptschalters Positionen sind, bei denen der dritte dynamische Kontakt (J3) jeweils die ersten statischen Kontakte (131, 132, 133) kontaktiert; die zweiten statischen Kontakte (141, 142, 143), die mit den ersten und zweiten dynamischen Kontakten (Q1, Q2) kontaktieren können, mit den ersten statischen Kontakten (131, 132, 133) entsprechend verbunden und weiterhin jeweils mit den entsprechenden Anzapfungen (1, 2, 3) des Transformators (L1) verbunden sind; so dass bei einem Prozess der Drehung der Drehwelle (4) im Uhrzeigersinn oder gegen den Uhrzeigersinn, der dritte statische Kontakt (J3) des Hauptschalters gem äß einer voreingestellten Zeitfolge des Schalters den ersten statischen Kontakt (131, 132 bzw.133) kontaktieren oder von diesem getrennt werden kann; wobei der erste und zweite dynamische Kontakt (Q1, Q2) gem äß der voreingestellten Zeitfolge des Schalters die zweiten statischen Kontakte (141, 142 bzw.143) kontaktieren oder von diesen getrennt werden k önnen;
   wobei der erste dynamische Kontakt (Q1) und der zweite dynamische Kontakt (Q2) jeweils auf beiden Seiten des dritten dynamischen Kontakts (J3) angeordnet sind; eine Mittelpunktposition des ersten dynamischen Kontakts (Q1) sich auf der linken Seite des Mittelpunkts des dritten dynamischen Kontakts (J3) befindet, und das Bogenma ß eines dazwischen eingeschlossenen Winkels 0,5 W betr ägt; eine Mittelpunktposition des zweiten dynamischen Kontakts (Q2) sich auf der rechten Seite des Mittelpunkts des dritten dynamischen Kontakts (J3) befindet, und das Bogenmaß eines dazwischen eingeschlossenen Winkels 0,5 W betr ägt; wobei W das Bogenmaß eines eingeschlossenen Winkels zwischen den Mittelpunktpositionen jeweils zweier (131 und 132; bzw. 132 und 133) der ersten statischen Kontakte ist;

wobei das erste Thyristor-Hilfsmodul (M1) und das zweite Thyristor-Hilfsmodul (M2) so konfiguriert sind, dass sie die gleiche Struktur aufweisen; der dritte dynamische Kontakt (J3) zum Verbinden mit einem gemeinsamen Endpunkt vorgesehen ist;

wobei die beiden Enden eines Hauptstromkreises des ersten Thyristor-Hilfsmoduls (M1) jeweils mit dem ersten dynamischen Kontakt (Q1) und dem gemeinsamen Endpunkt verbunden sind; und die beiden Enden eines Hauptstromkreises des zweiten Thyristor-Hilfsmoduls (M2) jeweils mit dem zweiten dynamischen Kontakt (Q2) und dem gemeinsamen Endpunkt verbunden sind; und

wobei ein dynamischer Kontakt jedes Steuerschalters (KA1, KB1, KA2, KB2) auf der Drehwelle (4) angeordnet und so konfiguriert ist, dass er sich mit der Drehwelle (4) mitdreht; wobei im Drehprozess der Drehwelle (4) das Schließen und Öffnen der Steuerschalter (KA1, KB1, KA2, KB2) ausgelöst wird, wenn die dynamischen Kontakte der Steuerschalter (KA1, KB1, KA2, KB2) die dritten und vierten statischen Kontakte (W3, W4) sowie die ersten und zweiten Auslösekontakte (11, 12) kontaktieren oder von diesen getrennt werden.

2. Lichtbogenfreier Laststufenschalter nach Anspruch 1, wobei wähend des Drehprozesses der Drehwelle (4) das Schließen und das Öffnen eines ersten Steuerschalters (KA1) des ersten Thyristor-Hilfsmoduls (M1) durch den dynamischen Kontakt (KA1) des ersten Steuerschalters (KA1) des ersten Thyristor-Hilfsmoduls (M1) ausgelöst wird, wenn dieser eine Reihe von bogenf örmigen Abschnitten des dritten statischen Kontakts (W3) passiert; das Schlie ßen und das Öffnen eines ersten Steuerschalters (KA2) des zweiten Thyristor-Hilfsmoduls (M2) durch den dynamischen Kontakt des ersten Steuerschalters (KA2) des zweiten Thyristor-Hilfsmoduls (M2) ausgelöst wird, wenn dieser eine Reihe von bogenförmigen Abschnitten des vierten statischen Kontakts (W4) passiert; das Schließen und das Öffnen eines zweiten Steuerschalters (KB1) des ersten Thyristor-Hilfsmoduls (M1) durch einen vierten dynamischen Kontakt (8) ausgelöst wird, wenn dieser einen ersten Auslösekontakt (11) kontaktiert oder von diesem getrennt wird; und das Schließen und das Öffnen eines zweiten Steuerschalters (KB2) des zweiten Thyristor-Hilfsmoduls (M2) durch den vierten dynamischen Kontakt (8) ausgelöst wird, wenn dieser einen zweiten Auslösekontakt (12) kontaktiert oder von diesem getrennt wird.

3. Lichtbogenfreier Laststufenschalter nach Anspruch 1, wobei die ersten statischen Kontakte (131, 132, 133) auf einer ersten bogenförmigen Bahn, die um die Drehachse zentriert ist, in gleichen Bogenabst änden und fest montiert sind;

die zweiten statischen Kontakte (141, 142, 143) auf einer zweiten bogenförmigen Bahn, die um die Drehwelle (4) zentriert ist, in gleichen Bogenabst änden und fest montiert sind; und
die ersten statischen Kontakte (131, 132, 133) den zweiten statischen Kontakten (141, 142, 143) paarweise entsprechen und deren Mittellinienpositionen in jedem Paar übereinstimmen; wobei die Beziehungen zwischen den Bogenl ängen aller statischen Kontakte (131, 132, 133, 141, 142, 143) wie folgt sind:

$$0 < \Delta W < W1 < 0.5W < W2,$$

$$\Delta W = \left( W - W2 \right),$$

wobei: $W1$ die Bogenl änge des ersten statischen Kontakts (131, 132, 133) ist; $W2$ die Bogenl änge der zweiten statischen Kontakte (141, 142, 143) ist; $W$ der Bogenabstand zwischen den Mittellinienpositionen zweier benachbarter erster statischer Kontakte ist; und $\Delta W$ der Bogenabstand einer Lücke zwischen zwei benachbarten zweiten statischen Kontakten ist.

4. Lichtbogenfreier Laststufenschalter nach Anspruch 1, wobei vor dem Schaltprozess des Hauptschalters ein normaler Betriebszustand des lichtbogenfreien Laststufenschalters umfasst:
im Zustand, in dem der dritte dynamische Kontakt (J3) auf der Mittellinie des ersten statischen Kontakts (132) befindet, befinden sich der erste und zweite dynamische Kontakt jeweils auf den Mittellinien der Lücken zwischen zwei benachbarten zweiten statischen Kontakten.

5. Lichtbogenfreier Laststufenschalter nach Anspruch 1, wobei das Schließen und das Öffnen der Steuerschalter (KB1, KB2) durch den Steuermechanismus gesteuert wird; wobei
der Steuermechanismus ein mechanischer Koppelmechanismus ist, umfassend:

eine Umlenkwelle (6), wobei die Umlenkwelle (6) fest auf der Drehwelle (4) angebracht ist und gemeinsam mit der Drehwelle (4) dreht, ein Hebelarm (7) und ein Federarm (8), die sich um die Umlenkwelle (6) drehen, auf der Umlenkwelle (6) montiert sind, wobei ein Ende des Federarms (8) mit einem vierten dynamischen Kontakt vorgesehen ist, und der vierte dynamische Kontakt gemeinsam mit der Drehwelle (4) dreht, um mit einem entsprechenden der Kontakte (11, 12) zu kontaktieren oder von diesem getrennt zu werden, wodurch die entsprechende der Steuerschalter (KB1, KB2) geöffnet oder geschlossen werden;

wahlweise eine Steuervorrichtung für den Steuermechanismus durch das Antreiben der Umschalter auf der Drehwelle (4) realisiert wird.

6. Lichtbogenfreier Laststufenschalter nach Anspruch 1, wobei
jeweils eines der ersten und zweiten Thyristor-Hilfsmodule (M1, M2) umfasst:

ein Paar Thyristoren (D1, D2), die antiparallel verbunden sind;
eine RC-Reihenschaltung (R1 und C1), die parallel an den beiden Enden des Paars der Thyristoren (D1, D2) verbunden ist;
einen Kondensator (C3, C4), einen Widerstand (R3, R4) und eine Diode (D3, D4), die jeweils zwischen einer Gate-Elektrode und einer Kathode jedes des Paars von Thyristoren (D1, D2) in Reihe verbunden sind; wobei
eine Anode der Diode (D3, D4) mit einer Kathode eines entsprechenden des Paars der Thyristoren (D1, D2) verbunden ist und eine Kathode der Diode (D3, D4) mit einer Gate-Elektrode des entsprechenden des Paars der Thyristoren (D1, D2) verbunden ist;
wobei die Gate-Elektroden des Paars der Thyristoren (D1, D2) in Reihe mit einem (KB) der beiden Steuerschalter über eine Vollbrücken-Gleichrichterschaltung verbunden sind; eine erste Spannungsstabilisierungröhre (D10), eine zweite Spannungsstabilisierungröhre (D11), ein Widerstand (R5) und ein weiterer (KA) der beiden Steuerschalter zwischen den Gate-Elektroden des Paars der Thyristoren (D1, D2) in Reihe verbunden sind; wobei die erste und zweite Spannungsstabilisierungröhre (D10, D11) antiseriell verbunden sind;
wobei eine dritte Spannungsstabilisierungröhre (D9) in Reihe mit einem Widerstand (R6) verbunden ist und dann mit einem Ausgangsende der Vollbrücken-Gleichrichterschaltung verbunden ist, wobei
eine Kathode der dritten Spannungsstabilisierungröhre (D9) mit einem Anoden-Ausgangsende der Vollbrücken-Gleichrichterschaltung verbunden ist und eine Anode der dritten Spannungsstabilisierungröhre (D9) mit einem Katho-

den-Ausgangsende der Vollbrücken-Gleichrichterschaltung verbunden ist.

7. Verfahren zur Schaltsteuerung für den lichtbogenfreien Laststufenschalter nach einem der Ansprüche 1 bis 6, wobei das Verfahren zur Schaltsteuerung umfasst:

Drehen der Drehwelle (4), um die dynamischen Kontakte (J3, Q1, Q2) so anzutreiben, dass sie gemäß der voreingestellten Zeitfolge des Schalters mit den entsprechenden statischen Kontakten (131, 132, 133, 141, 142, 143) kontaktieren oder von diesen getrennt werden; das Drehen der Drehwelle (4) treibt gleichzeitig die dynamischen Kontakte der Steuerschalter (KA1, KB1, KA2, KB2) an, so dass sie mit den dritten und vierten statischen Kontakten (W3, W4) sowie den ersten und zweiten Auslösekontakten (11, 12) kontaktieren oder von diesen getrennt werden, um das Schließen und Öffnen der Steuerschalter (KA1, KB1, KA2, KB2) auszulösen;
während der Drehung der Drehwelle (4) wird ein Laststrom von einem aktuellen Einschaltposition des Hauptschalters (J3) zu einer nächsten Einschaltposition des Hauptschalters (J3) ohne Unterbrechung übertragen, und es entsteht kein Lichtbogen bei den Abschalt- und Schließprozessen sämtlicher Schalter.

8. Verfahren zur Schaltsteuerung für den lichtbogenfreien Laststufenschalter nach Anspruch 7, wobei ein Drehmodus der Drehung der Drehwelle (4) eine Drehung im Uhrzeigersinn umfasst; wobei
ein Prozess eines einmaligen Schaltens des Hauptschalters (J3) umfasst:

bei Beginn der Drehung der Drehwelle (4) im Uhrzeigersinn,
das Beginnen der Bewegung des dritten dynamischen Kontakts (J3) von der Mittellinienposition des ersten statischen Kontakts (131 oder 132), den der dritte dynamische Kontakt (J3) aktuell kontaktiert, wobei der erste dynamische Kontakt (Q1) den zweiten statischen Kontakt (141 oder 142) kontaktiert, der entsprechend mit dem aktuell vom dritten dynamischen Kontakt (J3) kontaktierten ersten statischen Kontakt (131 oder 132) verbunden ist, und der zweite dynamische Kontakt (Q2) den zweiten statischen Kontakt (142 oder 143) kontaktiert, der entsprechend mit dem ersten statischen Kontakt (132 oder 133) verbunden ist, der als nächstes vom dritten dynamischen Kontakt (J3) kontaktiert wird;
das Schließen eines ersten Steuerschalters (KA1) des ersten Thyristor-Hilfsmoduls (M1), das zwischen dem Hauptschalter (J3) und dem ersten Umschalter (Q1) verbunden ist;

danach das Trennen des dritten dynamischen Kontakts (J3) vom ersten statischen Kontakt (131 oder 132), das Schlie ßen eines zweiten Steuerschalters (KB2) des zweiten Thyristor-Hilfsmoduls (M2), das zwischen dem Hauptschalter (J3) und dem zweiten Umschalter (Q2) verbunden ist, sowie gleichzeitige Abschalten des ersten Steuerschalters (KA1) des ersten Thyristor-Hilfsmoduls (M1);

nach einem voreingestellten Zeitintervall "t1" das Schlie ßen eines ersten Steuerschalters (KA2) des zweiten Thyristor-Hilfsmoduls (M2); wobei sich der dritte dynamische Kontakt (J3) zu dem ersten statischen Kontakt (132 oder 133) bewegt und diesen kontaktiert, der sich an der nächsten Einschaltposition des dritten dynamischen Kontakts (J3) befindet;

danach das Trennen des ersten und zweiten dynamischen Kontakts (Q1, Q2) von den zweiten statischen Kontakten (141/142 oder 142/143), das Abschalten des ersten Steuerschalters (KA2) des zweiten Thyristor-Hilfsmoduls (M2), und das Abschalten des zweiten Steuerschalters (KB2) des zweiten Thyristor-Hilfsmoduls (M2);

wenn der dritte dynamische Kontakt (J3) die Mittellinienposition des als nächstes kontaktierten ersten statischen Kontakts (132 oder 133) erreicht, das Stoppen der Drehung der Drehwelle (4), um das einmalige Schalten des Hauptschalters (J3) abzuschließen;

oder, vor dem Schalten des Hauptschalters (J3), dass sichergestellt ist, dass die Spannungen zwischen den beiden Enden der ersten und zweiten Thyristor-Hilfsmodule (M1, M2) null sind.

9. Verfahren zur Schaltsteuerung für den lichtbogenfreien Laststufenschalter nach Anspruch 7, wobei ein Drehmodus der Drehung der Drehwelle (4) eine Drehung gegen den Uhrzeigersinn umfasst; wobei ein Prozess eines einmaligen Schaltens des Hauptschalters umfasst:

bei Beginn der Drehung der Drehwelle (4) gegen den Uhrzeigersinn,

das Beginnen der Bewegung des dritten dynamischen Kontakts (J3) von der Mittellinienposition des ersten statischen Kontakts (133 oder 132), den der dritte dynamische Kontakt (J3) aktuell kontaktiert, wobei der zweite dynamische Kontakt (Q2) den zweiten statischen Kontakt (143 oder 142) kontaktiert, der entsprechend mit dem aktuell vom dritten dynamischen Kontakt (J3) kontaktierten ersten statischen Kontakt (133 oder 132) verbunden ist, und der erste dynamische Kontakt (Q1) den zweiten statischen Kontakt (142 oder 141) kontaktiert, der entsprechend mit dem ersten statischen Kontakt (132 oder 131) verbunden ist, der als nächstes vom dritten dynamischen Kontakt (J3) kontaktiert wird;

das Schließen eines ersten Steuerschalters (KA2) des zweiten Thyristor-Hilfsmoduls (M2), das zwischen dem Hauptschalter (J3) und dem zweiten Umschalter (Q2) verbunden ist;

danach das Trennen des dritten dynamischen Kontakts (J3) vom ersten statischen Kontakt (133 oder 132), das Schlie ßen eines zweiten Steuerschalters (KB1) des ersten Thyristor-Hilfsmoduls (M1), das zwischen dem Hauptschalter (J3) und dem ersten Umschalter (Q1) verbunden ist; sowie gleichzeitige Abschalten des ersten Steuerschalters (KA2) des zweiten Thyristor-Hilfsmoduls (M2);

nach einem voreingestellten Zeitintervall "t1" das Schließen eines ersten Steuerschalters (KA1) des ersten Thyristor-Hilfsmoduls (M1); wobei sich der dritte dynamische Kontakt (J3) zu dem ersten statischen Kontakt (132 oder 131) bewegt und diesen kontaktiert, der sich an der nächsten Einschaltposition des dritten dynamischen Kontakts (J3) befindet;

danach das Trennen des ersten und zweiten dynamischen Kontakts (Q2, Q1) von den zweiten statischen Kontakten (143/142 oder 142/141), das Abschalten des ersten Steuerschalters (KA1) des ersten Thyristor-Hilfsmoduls (M1), und das Abschalten des zweiten Steuerschalters (KB1) des ersten Thyristor-Hilfsmoduls (M1);

wenn der dritte dynamische Kontakt (J3) die Mittellinienposition des als nächstes kontaktierten ersten statischen Kontakts (132 oder 131) erreicht, das Stoppen der Drehung der Drehwelle (4), um das einmalige Schalten des Hauptschalters (J3) abzuschlie ßen;

oder, vor dem Schalten des Hauptschalters (J3), dass sichergestellt ist, dass die Spannungen zwischen den beiden Enden der ersten und zweiten Thyristor-Hilfsmodule (M1, M2) null sind.

10. Elektrisches Zubehör, umfassend:

eine Spannungsregelwicklung (L1), einschließlich einer Mehrzahl von Anzapfungen (1,2,3) eines Transformators; und

einen lichtbogenfreien Laststufenschalter, der mit der Spannungsregelwicklung (L1) verbunden ist;

wobei der lichtbogenfreie Laststufenschalter nach einem der Ansprüche 1 bis 6 ausgeführt ist.

**Revendications**

1. Changeur de prise en charge sans arc, comprenant au moins un commutateur principal (J3), un premier inverseur (Q1), un second inverseur (Q2), un premier module auxiliaire à thyristor (M1) et un second module auxiliaire à thyristor (M2) ; dans lequel le premier module auxiliaire à thyristor (M1) comprend deux commutateurs de commande (KA1, KB1), et le second module auxiliaire à thyristor (M2) comprend deux commutateurs de commande (KA2, KB2) ; des premiers contacts statiques (131, 132, 133) sont connectés à des prises (1, 2, 3) correspondantes sur une bobine de régulation de tension d'un transformateur (L1) ; dans lequel

le commutateur principal (J3) et les premier et second inverseurs (Q1, Q2) sont tous des commutateurs à arbre rotatif et sont disposés sur un arbre rotatif (4) ;
le commutateur principal (J3) comprend un troisième contact dynamique (J3) ; les premier et second inverseurs comprennent respectivement un premier contact dynamique (Q1) et un deuxième contact dynamique (Q2) ;
des positions d'enclenchement du commutateur principal sont des positions dans lesquelles le troisième contact dynamique (J3) entre en contact avec les premiers contacts statiques (131, 132, 133), respectivement ; deuxièmes contacts statiques (141, 142, 143), qui sont capables d'entrer en contact avec les premier et deuxième contacts dynamiques (Q1, Q2), sont connectés aux premiers contacts statiques (131, 132, 133), respectivement, et sont en outre connectés aux prises (1, 2, 3) correspondantes du transformateur (L1), respectivement ; de telle sorte que,
lors d'une rotation dans le sens horaire ou antihoraire de l'arbre rotatif (4), le troisième contact statique (J3) du commutateur principal puisse entrer en contact avec ou se séparer du premier contact statique (131, 132 ou 133) selon une séquence temporelle prédéfinie de commutation ; les premier et deuxième contacts dynamiques (Q1, Q2) puissent entrer en contact ou se séparer des deuxièmes contacts statiques (141, 142 ou 143) selon la séquence temporelle prédéfinie de commutation ;
le premier contact dynamique (Q1) et le deuxième contact dynamique (Q2) sont respectivement disposés sur deux côtés du troisième contact dynamique (J3) ; une position centrale du premier contact dynamique (Q1) est située sur le côté gauche d'un centre du troisième contact dynamique (J3), et un radian d'un angle inclus entre ceux-ci est de 0,5 W ; une position centrale du deuxième contact dynamique (Q2) est située sur le côté droit du centre du troisième contact dynamique (J3), et un radian d'un angle inclus entre ceux-ci est de 0,5 W ; dans lequel W est un radian d'un angle inclus entre des positions centrales de deux contacts statiques (131 et 132 ; ou 132 et 133) quelconques parmi les premiers contacts statiques ;
le premier module auxiliaire à thyristor (M1) et le second module auxiliaire à thyristor (M2) sont configurés pour avoir la même structure ; le troisième contact dynamique (J3) est destiné à être connecté à un point d'extrémité public ; deux extrémités d'un circuit principal du premier module auxiliaire à thyristor (M1) sont respectivement connectées au premier contact dynamique (Q1) et au point d'extrémité public ; et deux extrémités d'un circuit principal du second module auxiliaire à thyristor (M2) sont respectivement connectées au deuxième contact dynamique (Q2) et au point d'extrémité public ; et un contact dynamique de chacun des commutateurs de commande (KA1, KB1, KA2, KB2) est disposé sur l'arbre rotatif (4) et configuré pour tourner avec l'arbre rotatif (4) ; dans lequel, au cours du processus de rotation de l'arbre rotatif (4), la fermeture et l'ouverture des commutateurs de commande (KA1, KB1, KA2, KB2) sont déclenchées lorsque les contacts dynamiques des commutateurs de commande (KA1, KB1, KA2, KB2) entrent en contact ou se séparent de troisième et quatrième contacts statiques (W3, W4), et de premier et second contacts (11, 12) de déclenchement.

2. Changeur de prise en charge sans arc selon la revendication 1, dans lequel, au cours du processus de rotation de l'arbre rotatif (4), la fermeture et l'ouverture d'un premier commutateur de commande (KA1) du premier module auxiliaire à thyristor (M1) sont déclenchées par le contact dynamique (KA1) du premier commutateur de commande (KA1) du premier module auxiliaire à thyristor (M1) passant à travers une série de sections en forme d'arc du troisième contact statique (W3) ; la fermeture et l'ouverture d'un premier commutateur de commande (KA2) du second module auxiliaire à thyristor (M2) sont déclenchées par le contact dynamique du premier commutateur de commande (KA2) du second module auxiliaire à thyristor (M2) passant à travers une série de sections en forme d'arc du quatrième contact statique (W4) ; la fermeture et l'ouverture d'un second commutateur de commande (KB1) du premier module auxiliaire à thyristor (M1) sont déclenchées par un quatrième contact dynamique (8) qui entre en contact avec ou se sépare d'un premier contact (11) de déclenchement ; et la fermeture et l'ouverture d'un second commutateur de commande (KB2) du second module auxiliaire à thyristor (M2) sont déclenchées par le quatrième contact dynamique (8) qui entre en contact avec ou se sépare d'un second contact (12) de déclenchement.

3. Changeur de prise en charge sans arc selon la revendication 1, dans lequel les premiers contacts statiques (131, 132, 133) sont montés sur une première piste en forme d'arc centrée sur l'axe de rotation, à des distances d'arc égales et de manière fixe ;

les deuxièmes contacts statiques (141, 142, 143) sont montés sur une seconde piste en forme d'arc centrée sur l'arbre rotatif (4), à des distances d'arc égales et de manière fixe ; et les premiers contacts statiques (131, 132, 133) correspondent aux deuxièmes contacts statiques (141, 142, 143) par paires et des positions de ligne médiane de ceux-ci coïncident dans chacune des paires ;
dans lequel, des relations entre des longueurs d'arc de tous les contacts statiques (131, 132, 133, 141, 142, 143) sont les suivantes :

$$0 < \Delta W < W1 < 0.5W < W2,$$

$$\Delta W = (W - W2),$$

dans lequel : $W1$ est une longueur d'arc du premier contact statique (131, 132, 133) ; $W2$ est une longueur d'arc des deuxièmes contacts statiques (141, 142, 143) ; $W$ est une distance d'arc entre les positions de ligne centrale de deux premiers contacts statiques adjacents ; et, $\Delta W$ est une distance d'arc d'un espace entre deux deuxièmes contacts statiques adjacents.

4. Changeur de prise en charge sans arc selon la revendication 1, dans lequel, avant le processus de commutation du commutateur principal, un état de fonctionnement normal du changeur de prise en charge sans arc, comprenant :
dans un état dans lequel le troisième contact dynamique (J3) est situé sur une ligne centrale du premier contact statique (132), les premier et deuxième contacts dynamiques sont respectivement situés sur des lignes centrales d'espaces entre deux deuxièmes contacts statiques adjacents.

5. Changeur de prise en charge sans arc selon la revendication 1, dans lequel la fermeture et l'ouverture des commutateurs de commande (KB1, KB2) sont commandées par le mécanisme de commande ; dans lequel
le mécanisme de commande est un mécanisme de liaison mécanique, comprenant :

un arbre de déviation (6), dans lequel ledit arbre de déviation (6) est fixé sur l'arbre rotatif (4) et tourne avec l'arbre rotatif (4), un bras de levier (7) et un bras à ressort (8) tournant autour de l'arbre de déviation (6) sont montés sur ledit arbre de déviation (6), une extrémité du bras à ressort (8) est pourvue d'un quatrième contact dynamique, et le quatrième contact dynamique tourne avec l'arbre rotatif (4) pour entrer en contact avec ou se séparer de l'un contact correspondant des contacts (11, 12), afin de provoquer respectivement l'ouverture ou la fermeture de l'un commutateur de commande correspondant des commutateurs de commande (KB1, KB2) ;
optionnellement, un moyen de commande pour le mécanisme de commande est réalisé en entraînant les inverseurs sur l'arbre rotatif (4).

6. Changeur de prise en charge sans arc selon la revendication 1, dans lequel
chacun des premier et second modules auxiliaires à thyristor (M1, M2) comprend :

une paire de thyristors (D1, D2) est connectée en parallèle inverse ;
un circuit série RC (R1 et C1) est connecté en parallèle au niveau de deux extrémités de la paire de thyristors (D1, D2) ;
un condensateur (C3, C4), une résistance (R3, R4) et une diode (D3, D4) sont connectés séquentiellement entre une électrode de grille et une cathode de chacun de la paire de thyristors (D1, D2) ; dans lequel
une anode de la diode (D3, D4) est connectée à une cathode de l'un thyristor (D1, D2) correspondant de la paire de thyristors, et une cathode de la diode (D3, D4) est connectée à une électrode de grille de l'un thyristor (D1, D2) correspondant de la paire de thyristors ;
les électrodes de grille de la paire de thyristors (D1, D2) sont connectées en série avec l'un (KB) des deux commutateurs de commande par l'intermédiaire d'un circuit redresseur en pont complet ; un premier tube stabilisateur de tension (D10), un deuxième tube stabilisateur de tension (D11), une résistance (R5) et l'autre (KA) des deux commutateurs de commande sont connectés en série entre les électrodes de grille de la paire de thyristors (D1, D2) ; dans lequel les premier et deuxième tubes stabilisateurs de tension (D10, D11) sont connectés en série inverse ;
un troisième tube stabilisateur de tension (D9) est connecté en série avec une résistance (R6), puis connecté à une extrémité de sortie du circuit redresseur en pont complet, dans lequel une cathode du troisième tube stabilisateur de tension (D9) est connectée à une extrémité de sortie anodique du circuit redresseur en pont complet, et une anode du troisième tube stabilisateur de tension (D9) est connectée à une extrémité de sortie cathodique du circuit redresseur en pont complet.

7. Procédé de commande de commutation pour le changeur de prise en charge sans arc selon l'une quelconque des revendications 1 à 6, et ledit procédé de commande de commutation comprenant :

    la rotation de l'arbre rotatif (4) pour entraîner les contacts dynamiques (J3, Q1, Q2) pour qu'ils entrent en contact avec ou se séparent de contacts statiques correspondants des contacts statiques (131, 132, 133, 141, 142, 143) selon la séquence temporelle prédéfinie de commutation ; simultanément, la rotation de l'arbre rotatif (4) pour entraîner les contacts dynamiques des commutateurs de commande (KA1, KB1, KA2, KB2) pour qu'ils entrent en contact avec ou se séparent des troisième et quatrième contacts statiques (W3, W4), ainsi que des premier et second contacts (11, 12) de déclenchement, afin de déclencher la fermeture et l'ouverture des commutateurs de commande (KA1, KB1, KA2, KB2) ;
    dans lequel, lors de la rotation de l'arbre rotatif (4), un courant de charge est transféré d'une position d'enclenchement actuelle du commutateur principal (J3) à une position d'enclenchement suivante du commutateur principal (J3) sans interruption, et sans arc lors des processus d'ouverture et de fermeture de tous les commutateurs.

8. Procédé de commande de commutation pour le changeur de prise en charge sans arc selon la revendication 7, dans lequel un mode de rotation de l'arbre rotatif (4) comprend une rotation dans le sens horaire ; dans lequel
    un processus de commutation unique du commutateur principal (J3), comprenant :

    lorsque l'arbre rotatif (4) commence une rotation dans le sens horaire,
    le troisième contact dynamique (J3) commence à se déplacer à partir de la position de ligne centrale du premier contact statique (131 ou 132) avec lequel le troisième contact dynamique (J3) entre actuellement en contact, le premier contact dynamique (Q1) entre en contact avec le deuxième contact statique (141 ou 142) connecté de manière correspondante au premier contact statique (131 ou 132) avec lequel le troisième contact dynamique (J3) entre actuellement en contact, le deuxième contact dynamique (Q2) entre en contact avec le deuxième contact statique (142 ou 143) connecté de manière correspondante au premier contact statique (132 ou 133) avec lequel le troisième contact dynamique (J3) doit entrer en contact ;
la fermeture d'un premier commutateur de commande (KA1) du premier module auxiliaire à thyristor (M1) connecté entre le commutateur principal (J3) et le premier inverseur (Q1) ;
ensuite, lorsque le troisième contact dynamique (J3) est libéré du premier contact statique (131 ou 132), la fermeture d'un second commutateur de commande (KB2) du second module auxiliaire à thyristor (M2) connecté entre le commutateur principal (J3) et le second inverseur (Q2) ;
simultanément, l'ouverture du premier commutateur de commande (KA1) du premier module auxiliaire à thyristor (M1) ;
après un intervalle de temps prédéfini « t1 », la fermeture d'un premier commutateur de commande (KA2) du second module auxiliaire à thyristor (M2) ; dans lequel le troisième contact dynamique (J3) se déplace vers et entre en contact avec le premier contact statique (132 ou 133) situé dans la position d'enclenchement suivante du troisième contact dynamique (J3) ;
ensuite, lorsque les premier et deuxième contacts dynamiques (Q1, Q2) sont libérés des deuxièmes contacts statiques (141/142 ou 142/143), l'ouverture du premier commutateur de commande (KA2) du second module auxiliaire à thyristor (M2) ; l'ouverture du second commutateur de commande (KB2) du second module auxiliaire à thyristor (M2) ;
lorsque le troisième contact dynamique (J3) atteint la position de ligne centrale du premier contact statique (132 ou 133) en contact ensuite, l'arrêt de la rotation de l'arbre rotatif (4), afin de terminer la commutation unique du commutateur principal (J3) ;
ou, avant la commutation du commutateur principal (J3), les tensions entre les deux extrémités des premier et second modules auxiliaires à thyristor (M1, M2) sont nulles.

9. Procédé de commande de commutation pour le changeur de prise en charge sans arc selon la revendication 7, dans lequel un mode de rotation de l'arbre rotatif (4) comprend une rotation dans le sens antihoraire ; dans lequel
    un processus de commutation unique du commutateur principal, comprenant :

    lorsque l'arbre rotatif (4) commence une rotation dans le sens antihoraire,
    le troisième contact dynamique (J3) commence à se déplacer à partir de la position de ligne centrale du premier contact statique (133 ou 132) avec lequel le troisième contact dynamique (J3) entre actuellement en contact, le deuxième contact dynamique (Q2) entre en contact avec le deuxième contact statique (143 ou 142) connecté de manière correspondante au premier contact statique (133 ou 132) avec lequel le troisième contact dynamique (J3) entre actuellement en contact, le premier contact dynamique (Q1) entre en contact avec le deuxième contact statique (142 ou 141) connecté de manière correspondante au premier contact statique (132 ou 131) avec lequel le troisième contact dynamique (J3) doit entrer en contact ; la fermeture d'un premier commutateur de commande (KA2) du second module auxiliaire à thyristor (M2) connecté entre le commutateur principal (J3) et le second inverseur (Q2) ; ensuite, lorsque le troisième contact dynamique (J3) est libéré du premier contact statique (133 ou 132), la fermeture d'un second commutateur de commande (KB1) du premier module auxiliaire à thyristor (M1) connecté entre le commutateur principal (J3) et le premier inverseur (Q1) ; simultanément, l'ouverture du premier commutateur de commande (KA2) du second module auxiliaire à thyristor (M2) ; après un intervalle de temps prédéfini « t1 », la fermeture d'un premier commutateur de commande (KA1) du premier module auxiliaire à thyristor (M1) ; dans lequel le troisième contact dynamique (J3) se déplace vers et entre en contact avec le premier contact statique (132 ou 131) situé dans la position d'enclenchement suivante du troisième contact dynamique (J3) ; ensuite, lorsque les deuxième et premier contacts dynamiques (Q2, Q1) sont libérés des deuxièmes contacts statiques (143/142 ou 142/141), l'ouverture du premier commutateur de commande (KA1) du premier module auxiliaire à thyristor (M1) ; l'ouverture du second commutateur de commande (KB1) du premier module auxiliaire à thyristor (M1) ; lorsque le troisième contact dynamique (J3) atteint la position de ligne centrale du prochain premier contact statique (132 ou 131) en contact, l'arrêt de la rotation de l'arbre rotatif (4), afin de terminer la commutation unique du commutateur principal (J3) ; ou, avant la commutation du commutateur principal (J3), les tensions entre les deux extrémités des premier et second modules auxiliaires à thyristor (M1, M2) sont nulles.

10. Accessoire électrique, comprenant :

une bobine de régulation de tension (L1), comportant une pluralité de prises (1, 2, 3) d'un transformateur ; et

un changeur de prise en charge sans arc, qui est connecté à la bobine de régulation de tension (L1) ;

dans lequel le changeur de prise en charge sans arc est décrit selon l'une quelconque des revendications 1 à 6.

**FIG. 1**

**FIG. 2**

**FIG. 3**

**FIG. 4**

**FIG. 5**

**FIG. 6**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210232941
- CN 103019284 A
- CN 103633978 A
- CN 104113317 A
- CN 108768359 A
- CN 201810290470

**Non-patent literature cited in the description**

- Electrical Mechanism of On-Load Tap Changer. China Electric Power Press, 2012, 63-66